Europäisches Patentamt

European Patent Office

Office européen des brevets

(19)

(11) Numéro de publication : **0 399 897 B1**

# FASCICULE DE BREVET EUROPEEN

(12)

(45) Date de publication du fascicule du brevet :
**23.03.94 Bulletin 94/12**

(51) Int. Cl.⁵ : **H04H 9/00,** H04N 7/00,
A63F 9/22, G06F 15/44

(21) Numéro de dépôt : **90401362.0**

(22) Date de dépôt : **22.05.90**

(54) **Système de participation individuelle à un programme télédiffusé.**

(30) Priorité : **25.05.89 FR 8906848**
**09.02.90 FR 9001512**

(43) Date de publication de la demande :
**28.11.90 Bulletin 90/48**

(45) Mention de la délivrance du brevet :
**23.03.94 Bulletin 94/12**

(84) Etats contractants désignés :
**AT BE CH DE DK ES FR GB GR IT LI LU NL SE**

(56) Documents cités :
**WO-A-86/07277**
**US-A- 4 359 220**
**US-A- 4 592 546**
**US-A- 4 745 468**

(73) Titulaire : **ADVENTURE**
**2, rue Maurice Hartmann**
**F-92130 Issy-les-Moulineaux (FR)**

(72) Inventeur : **Audebert, Yves**
**2 allée Jehan Le Jeune**
**F-78290 Croissy-sur-Seine (FR)**
Inventeur : **Delahaye, Achille**
**25 rue Désiré Richebois**
**F-94120 Fontenay-sous-Bois (FR)**

(74) Mandataire : **Colas, Jean-Pierre et al**
**Cabinet de Boisse 37, avenue Franklin D.**
**Roosevelt**
**F-75008 Paris (FR)**

## Description

L'invention est relative à un sytème comprenant un dispositif électronique destiné à permettre à au moins un individu, d'une part, de participer depuis un poste de réception à un programme télédiffusé, et, d'autre part, de certifier ladite participation en liaison avec un serveur.

Le brevet US-A-4 745 468 décrit un système permettant d'évaluer les réponses données par des auditeurs ou des téléspectateurs à des questions posées au cours d'un programme radiophonique ou de télévision. La station qui diffuse le programme transmet concouramment sur un autre canal de radiodiffusion un signal d'instructions contenant des données représentant la question à laquelle il convient de répondre, le laps de temps imparti pour formuler une réponse et le contenu et la forme de la réponse correcte. Ces données sont téléchargées dans des consoles dont sont équipés les individus souhaitant participer au programme diffusé. A cet effet les consoles comportent un moyen spécifique de réception du signal d'instructions.

Chaque console comporte des moyens de temporisation qui imposent au participant de formuler sa réponse dans le délai imparti, réponse qui est introduite dans la console par l'intermédiaire d'un clavier. Dans la console, des moyens de traitement comparent la réponse du participant avec la réponse correcte téléchargée, calculent le résultat, gain ou score obtenu par le participant, et le cumulent avec le score accumulé précédemment.

Le score cumulé peut ensuite être transféré, éventuellement sous forme chiffrée, sur un support d'enregistrement à lecture magnétique (carte à piste magnétique) ou optique (feuille imprimée ou perforée). Ce support d'enregistrement permet ainsi à l'utilisateur de la console de prouver sa participation au programme diffusé et, en liaison avec un serveur, de valider le résultat obtenu. En échange, le participant pourra se voir éventuellement remettre un prix sous forme d'argent, de lot, de réduction sur des marchandises ou services, etc...

Toutefois, ce système, tel qu'il est décrit dans le brevet US 4 745 648, présente une lacune sérieuse en ce qu'il n'interdit pas à un individu d'enregistrer le programme diffusé et le signal d'instructions précité sur un magnétoscope et/ou un magnétophone, de prendre connaissance des bonnes réponses aux questions posées, de participer en différé au programme au moyen de l'enregistrement effectué, et de faire ensuite valider le score obtenu frauduleusement.

Le brevet U.S. 4 592 546 décrit un système similaire permettant à des téléspectateurs d'effectuer un pari sur le résultat d'un événement, tel qu'un match de foot-ball, avant sa diffusion par une station de télévision.

Pour parier, les téléspectateurs disposent d'une console pourvue d'un récepteur lui permettant de recevoir des signaux radioélectriques émis par une station centrale. La console est équipée d'une horloge temps réel calée sur une échelle de temps absolu pour déterminer, dans la console, la date précise à laquelle le téléspectateur fait son pari. La date limite de pari (date de coup d'envoi d'un match de foot-ball par exemple) est transmise depuis la station centrale aux consoles par voie radioélectrique et la console ne prend en compte le pari effectué par le téléspectateur que si celui-ci est intervenu avant la date limite.

A des fins de vérification, la console est également pourvue de dix compteurs qui sont déclenchés à des dates aléatoires par des signaux transmis depuis la station centrale. Lorsqu'un joueur veut faire valider ses gains, il met sa console en communication avec la station centrale par l'intermédiaire d'une ligne téléphonique et son résultat n'est validé que si l'état des compteurs de la console est à cet instant identique à celui de compteurs homologues de la station centrale, dont le comptage a démarré au moment de l'émission des signaux précités.

Selon ce brevet U.S. 4 592 546, la prise en compte du pari repose fondamentalement sur l'attribution à celui-ci d'une date absolue très précise par l'horloge équipant la console. Cette horloge doit donc être d'une très grande précision (quartz de type horlogerie par exemple) car la dérive totale de cette horloge sur toute la durée de vie de la console ne devra pas excéder une valeur maximale très faible. Or, de telles horloges sont relativement onéreuses. L'utilisation d'horloges moins performantes, et donc moins coûteuses, combinée à une procédure spéciale de mise à l'heure de l'horloge par un organisme habilité pourrait être envisagée, mais un tel système serait une source de difficultés (risques de fraude, de contestation, etc...).

Par ailleurs, la procédure de vérification vise à éviter la fraude qui consisterait à empêcher la réception par une console de la date limite réelle et à permettre un pari différé grâce à une falsification de cette date limite. La procédure de vérification n'est pas réellement satisfaisante car elle repose également sur la transmission aux consoles, pendant le déroulement du programme, de signaux extérieurs : une telle transmission présente toujours des aléas sources de difficultés techniques et de contestations en cas de fonctionnement défectueux.

L'invention vise à fournir un système comprenant un dispositif électronique permettant à un individu de participer à un programme télédiffusé reçu sur un récepteur de télévision ou radiophonique, un terminal télématique ou informatique, ou tout autre poste de réception d'un programme, en introduisant dans son dispositif au moins une donnée de participation qui peut être, par exemple, une réponse à une question posée dans le cadre du programme diffusé, un pari sur un événement à venir, un code aléatoire ou pseudo-aléatoire dans le cadre d'un jeu de loterie ou similaire, etc... En outre, tout en étant d'un faible coût permettant sa diffusion à grande échelle, c'est-à-dire sans nécessiter une horloge temps réel de précision calée sur une échelle de temps absolu, ce dispositif doit être capable, en liaison avec un serveur, de certifier que la donnée de participation a bien été introduite dans le dispositif avant une date limite absolue donnée.

Un autre but de l'invention est de fournir un dispositif qui soit autonome, c'est-à-dire possédant sa propre source d'alimentation électrique et présentant par conséquent une faible consommation électrique, et qui ne nécessite pas de liaison permanente avec un serveur lorsque son utilisateur participe à un programme télédiffusé.

Il est également souhaitable qu'un tel dispositif soit portable et d'un encombrement réduit, tout en étant doté de moyens d'entrée et de sortie de données ergonomiques pour faciliter l'introduction de données de participation, la certification de la participation en liaison avec un serveur et, si nécessaire, le téléchargement d'un scénario. Un scénario comprend l'ensemble des paramètres qui, en fonction du programme télédiffusé, déterminent dans le dispositif les conditions de participation à ce programme.

Un autre but de l'invention est qu'un tel dispositif offre un degré élevé de protection contre les fraudes.

Pour atteindre ces buts, ainsi que d'autres, l'invention a pour objet un système de participation d'au moins un individu à un programme télédiffusé, selon un scénario mémorisé dans un dispositif électronique individuel et autonome de participation, et de certification de ladite participation en liaison avec un serveur, ledit dispositif comprenant :

- des moyens d'interface pour l'introduction par un participant d'au moins une donnée représentative de ladite participation audit programme et l'établissement d'une liaison de certification avec ledit serveur,
- des moyens de mémorisation de ladite donnée de participation et dudit scénario, et
- une horloge,

caractérisé en ce que :

- le dispositif comprend des moyens pour mesurer le temps relatif $\delta T_{int}$ écoulé entre au moins un premier événement dudit scénario corrélé chronologiquement à ladite introduction d'une donnée de participation dans le dispositif et l'établissement de ladite liaison de certification avec le serveur,
- le serveur comprend des moyens pour mesurer le temps relatif $\delta T_{ref}$ écoulé entre au moins un second événement dudit programme corrélé chronologiquement à une date limite absolue d'introduction de ladite donnée de participation et l'établissement de ladite liaison de certification, et

- le dispositif et/ou le serveur comporte(nt) des moyens pour comparer les temps relatifs mesurés dans le dispositif et le serveur et certifier ou non ladite participation en fonction du résultat de ladite comparaison.

Avec ce système, la datation de la participation à un programme ne fait pas appel à la transmission au dispositif de signaux extérieurs pendant le déroulement du programme. La mesure de temps dans le dispositif est en effet déclenchée par un événement du scénario qui se déroule dans ce dernier. La datation intervient a posteriori, c'est-à-dire au moment où l'utilisateur établit une liaison de certification avec le serveur. Il est donc possible de participer au programme en temps réel, mais également en différé. Toutefois, dans ce dernier cas, la participation ne sera pas certifiée car le temps $\delta T_{int}$ mesuré dans le dispositif ne sera pas cohérent avec le temps de référence $\delta T_{ref}$ mesuré par le serveur.

Le dispositif de participation ne nécessite pas une horloge de grande précision car sa dérive ne sera cumulée que sur la période de temps qui sépare un instant donné du déroulement du programme de l'établissement de la liaison de certification. Il suffit d'imposer aux utilisateurs de faire certifier leur participation dans un délai relativement court (quelques heures à quelques jours), ce qui ne pose pas en pratique de difficulté particulière, pour s'affranchir aisément de ces problèmes de dérive. Le dispositif de participation ne fait donc pas appel à des composant coûteux tout en assurant des conditions de certification très fiables.

De préférence, ledit premier événement est constitué par ladite introduction d'une donnée de participation dans le dispositif et le second événement par la date limite absolue d'introduction de cette donnée de participation, date limite qui est connue du serveur. Le processus de certification est dans ce cas particulièrement fiable car il repose sur une mesure de temps déclenchée par l'utilisateur lorsqu'il introduit une donnée de participation dans le dispositif, dont les circuits électroniques peuvent aisément être rendus inaccessibles à toute intervention extérieure comme cela sera décrit dans la suite.

Selon une caractéristique de l'invention, le scénario comprend des paramètres représentatifs du déroulement chronologique dudit programme et le dispositif comprend des moyens de temporisation pour la mise en oeuvre dudit scénario selon ladite chronologie. De préférence, ces paramètres sont téléchargés dans le dispositif mais, en variante, ils peuvent être programmés dans celui-ci au moment de sa personnalisation dans l'hypothèse où le déroulement chronologique des programmes sujets à participation est standardisé.

De préférence, le dispositif comprend des moyens de traitement de données pour produire un résultat fonction de ladite donnée de participation et les moyens de comparaison sont adaptés pour certifier ou non ledit résultat.

Le résultat certifié peut être crédité à son bénéficiaire dans des moyens de mémorisation disposés dans le serveur et/ou dans son dispositif. De même, les moyens de comparaison peuvent faire partie du serveur et/ou du dispositif. Dans chaque cas, le dispositif et le serveur comportent de préférence des moyens complémentaires d'authentification visant à vérifier la recevabilité d'une demande de certification.

Selon une forme préférée de réalisation de l'invention, le résultat certifié est crédité dans le dispositif et les moyens de comparaison sont disposés dans le serveur.

Selon encore une autre caractéristique, le sytème comprend :

- des dispositifs de participation associés chacun à un individu participant audit programme,
- des moyens de diffusion dudit programme à des poste de réception, et
- des terminaux pour l'établissement de liaisons de certification entre lesdits dispositifs de participation et ledit serveur.

Les autres caractéristiques de l'invention sont définies dans les revendications.

Différents modes de réalisation de l'invention donnés à titre d'exemple seront décrits ci-après en référence avec les dessins annexés sur lesquels :

La figure 1 est un schéma synoptique simplifié d'un dispositif portable électronique selon une forme de réalisation de l'invention.

La figure 2 est une vue en plan du dispositif.

La figure 3 est une vue suivant la flèche III, figure 2.

La figure 4 est un schéma illustrant l'utilisation du dispositif en liaison avec un poste récepteur de télévision.

La figure 5 est un schéma fonctionnel illustrant les étapes d'un processus de certification et d'authentification au moyen d'un premier mode de réalisation du dispositif de l'invention.

La figure 6 est un diagramme illustrant la fonction de certification assurée par le processus de la figure 5.

La figure 7 est un schéma illustrant la mise en oeuvre du processus de certification et d'authentification de la figure 5.

La figure 8 est un schéma illustrant la mise en oeuvre du processus de certification et d'authentification de la figure 5 au moyen d'un terminal à écran et clavier connecté à un serveur.

La figure 9 est un schéma similaire à celui de la figure 7 illustrant la mise en oeuvre du processus de certification et d'authentification avec un dispositif selon une deuxième forme préférée de réalisation de l'invention.

La figure 10 est un schéma similaire à celui de la figure 9 illustrant la mise en oeuvre du processus de certification et d'authentification avec un dispositif selon une troisième forme de réalisation de l'invention.

La figure 11 est une vue schématique en perspective d'un terminal utilisable en liaison avec le dispositif de la figure 1, et

La figure 12 est un schéma fonctionnel illustrant des échanges de données entre le terminal de la figure 11 et le dispositif de la figure 1.

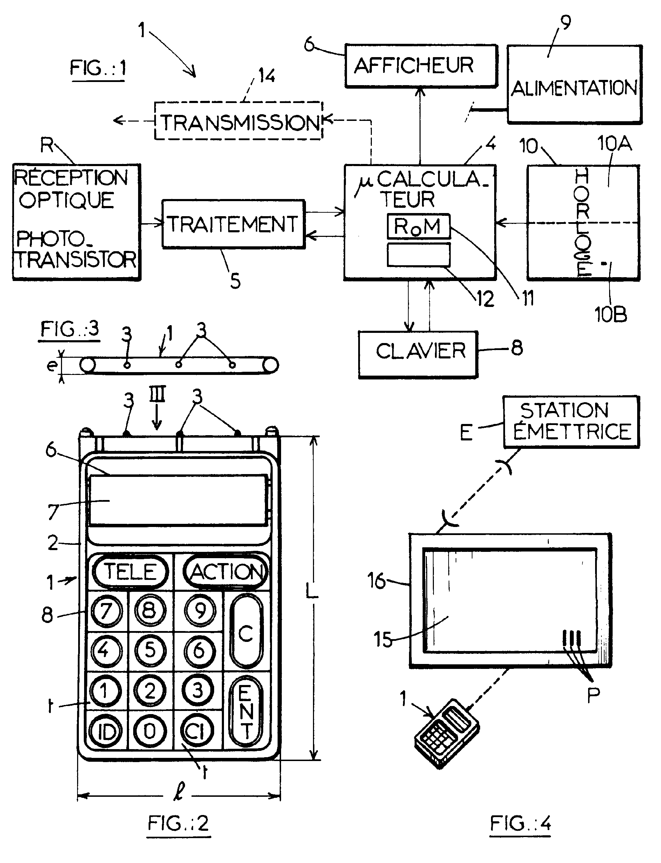

En se reportant aux dessins, notamment aux figures 1 à 3, on peut voir un dispositif portable électronique 1 destiné à recevoir sous forme optique des données d'un écran. Un dispositif de ce type est décrit en détail dans la demande de brevet français FR-A-2 630 561 à laquelle on pourra se référer.

Ce dispositif comprend un boîtier extérieur 2 de forme parallélépipédique rectangle, de préférence en matière plastique, et dont l'épaisseur $e$ (figure 3) est faible, par rapport à sa largeur $l$ et sa longueur L. De préférence, la taille du boîtier est adaptée pour que celui-ci puisse être tenu dans une main.

Le dispositif comprend des moyens de réception optique R avantageusement constitués par des phototransistors 3 (figures 2 et 3) disposés sur la tranche d'un petit côté du boîtier 2, et en particulier alignés. Dans l'exemple considéré, les phototransistors sont au nombre de trois.

Les moyens de réception R, comme illustré sur la figure 1, sont reliés à un microcalculateur 4, par l'intermédiaire de moyens de traitement 5 propres à convertir les signaux lumineux reçus en signaux électriques de format adapté au microcalculateurs 4.

Le dispositif 1 comprend un afficheur 6, de préférence cristaux liquide (LCD), formant un écran rectangulaire 7 (figure 2) sur le boîtier. De préférence, cet écran 7 est prévu pour afficher huit caractères alphanumériques, alignés. L'afficheur 6 permet de visualiser des informations provenant du microcalculateur.

Une source d'énergie électrique 9, généralement constituée par une pile électrique de dimensions réduites, est prévue pour alimenter les divers circuits. De préférence cette pile est noyée dans le boîtier 2 lors de la fabrication du dispositif de manière à être rendue inaccessible et à interdire son remplacement ainsi que tout accès aux conducteurs d'alimentation des différents circuits électroniques du dispositif, également noyés dans le boîtier 2. En variante, cette pile inaccessible peut être réservée à l'alimentation des circuits d'horloge et de mémoire RAM et les autres circuits peuvent être alimentés par une pile interchangeable.

Le dispositif comporte encore un clavier 8 notamment constitué, comme représenté sur la figure 2, par des touches $t$ dont dix d'entre elles correspondent respectivement aux dix chiffres 0 à 9. Le clavier 8 est complété par un certain nombre de touches de fonction, à savoir :

- une touche "TELE" qui permet de passer en mode optique pour le téléchargement de données depuis un écran ; en variante, cette touche peut être supprimée si le microcalculateur 4 est programmé pour être activé par des interruptions provenant des moyens de réception optique R et de traitement 5 ;
- une touche "C" qui permet d'effacer une entrée de donnée erronée ;
- une touche "ENT" qui permet d accepter une entrée de donnée ;
- une touche "ACTION" qui permet de mettre en oeuvre des jeux ne nécessitant pas la réception de données par les moyens de réception optique R ;
- une touche "CL" qui permet d'afficher sur l'écran 7 des gains réalisés avec le dispositif ;
- une touche "ID" qui permet de passer en mode identification si le dispositif est équipé de cette fonction et de mettre en oeuvre une procédure manuelle de certification et d'authentification.

Le microcalculateur 4 est un microcalculateur masqué, en technologie CMOS. Il peut être du type MC68HCφ5B6, de Motorola, pour une version microcalculateur autoprogrammable, ou du type NEC 753φ8 pour une version à mémoire de stockage RAM, ou alors du type circuit spécifique (ASIC) pour une version à RAM protégée. Le circuit spécifique sera développé à partir d'un microcalculateur standard des types précédents dans lesquels on inclura les moyens de protection de la mémoire. Ces moyens de protection pourront être constitués par un fusible grillé après écriture de la mémoire.

Le microcalculateur comporte une mémoire morte (ROM) 11 et une mémoire de stockage 12.

La mémoire morte 11 est organisée en deux zones, à savoir:
- une zone programme dans laquelle sont stockées les instructions relatives à :
- la fonction de décodage et réception optique;
- la fonction éventuelle d'identification ;
- la fonction d'authentification ;
- la fonction personnalisation du dispositif ;
- les fonctions applicatives permettant la mise en oeuvre de jeux télévisés ou autres ;
  - et une zone fabrication pour mémoriser les informations relatives à la fabrication de la carte et pour initialiser le produit, ces informations concernant :
- le code client ;
- le numéro du masque utilisé pour le microcalculateur ;
- la clé de fabrication, notamment constituée par 128 bits, permettant le contrôle de la personnalisation.

La mémoire de stockage 12 du dispositif contient deux catégories de données, à savoir :
- des données d'exploitation, pour le stockage d'informations concernant, par exemple, un pari ou un jeu, ou d'autres applications si la mémoire morte est programmée à cet effet ; et
- des données de personnalisation contenant les informations relatives :
  - au code confidentiel, si la fonction d'identification est programmée en mémoire morte ;
  - à la clé secrète d'authentification ;
  - aux paramètres d'exploitation (par exemple blocage de la carte au bout de quatre essais infructueux d'identification) ;
  - les diverses clés secrètes éventuellement nécessaires pour les fonctions applicatives ;
  - la durée de vie autorisée du dispositif.

La mémoire de stockage 12 peut être une PROM ou une EEPROM, ou avantageusement une RAM sauvegardée par la source d'alimentation. La mémoire RAM est inaccessible de l'extérieur du dispositif et toute tentative provoque l'effacement des informations qui y sont inscrites et rend le dispositif inutilisable. Les données de personnalisation y sont stockées une fois pour toutes, les données d'exploitation sont modifiables. La protection des données de personnalisation en mémoire RAM 12 résulte de la simple programmation structurée du microcalculateur 4.

Le bus de données et le bus d'adresses (non représentés sur les dessins) du microcalculateur 4 ne sont pas accessibles de l'extérieur, de manière à rendre impossible une lecture ou une modification frauduleuse, depuis l'extérieur, des informations contenues dans la mémoire morte 11 et la mémoire de stockage 12 du dispositif 1.

Si le microcalculateur 4 est programmé pour assurer une fonction d'identification, le dispositif ne peut être rendu actif qu'après actionnement de la touche ID et introduction, sur le clavier 8, d'un code confidentiel d'identification PIN de l'utilisateur du dispositif. Ce code confidentiel est connu seulement du titulaire du dispositif 1.

Le programme stocké dans la mémoire 11 peut en outre être prévu pour bloquer le dispositif 1 après entrée consécutive d'un certain nombre de codes confidentiels erronés sur le clavier 8, par exemple quatre codes. Le dispositif 1 devient alors inutilisable, et la réactivation du dispositif ne peut être assurée que par une procédure spéciale par exemple sur un centre serveur.

De manière facultative, le dispositif 1 peut être pourvu de moyens spécifiques 14 de transmission de données vers l'extérieur, notamment vers un serveur, en vue de la mise en oeuvre de procédures qui seront décrites dans la suite. Ces moyens de transmission peuvent être de nature optique, électrique, radioélectrique, acoustique ou autre et revêtir toute forme appropriée connue des spécialistes de la technique.

En dehors de l'horloge système (non représentée) propre au microcalculateur 4, le dispositif 1 est également équipé d'une horloge 10. Cette horloge peut être constituée par exemple d'une base de temps 10A et d'un compteur 10B alimentés en permanence par la source d'alimentation 9. A chaque débordement de son contenu, c'est-à-dire à intervalles réguliers, le compteur 10B émet une impulsion de réveil du microcalculateur 4. Celui-ci incrémente le temps écoulé depuis la personnalisation du dispositif et repasse ensuite à l'état de veille jusqu'à l'apparition de l'impulsion suivante en provenance du compteur 10B. Lorsque la durée de vie autorisée du dispositif est écoulée, cette information étant mémorisée dans la mémoire 12 lors de la personnalisation du dispositif, le microcalculateur 4 est programmé pour inhiber automatiquement le fonctionnement du dispositif 1, par exemple par effacement du contenu des informations de personnalisation dans la mémoire 12.

L'horloge 10 a également pour rôle, avec le microcalculateur 4, d'assurer la certification des résultats ou gains obtenus après une participation à un programme de télévision ou similaire.

Les programmes concernés peuvent être de différentes natures :

- il peut s'agir, par exemple, de jeux télévisés, d'émissions sportives, culturelles, pédagogiques, de films, etc... à l'occasion desquels le spectateur doit répondre à une ou plusieurs questions posées pendant ou à la fin du déroulement de l'émission ;
- il peut également s'agir de jeux de hasard du type loterie ou tirage dans lesquels, par exemple après téléchargement d'un nombre aléatoire ou pseudo-aléatoire dans le dispositif, le joueur dispose d'un certain délai pour effectuer, par l'intermédiaire du clavier 8, un pari pouvant consister en la mise d'une certaine somme ou d'un certain nombre de points préalablement chargés ou gagnés dans le dispositif. Cette somme ou ces points peuvent avoir été crédités préalablement dans la mémoire 12 du dispositif grâce à la fonction porte-monnaie décrite dans la demande de brevet FR-A-2 630 561. A l'issue de ce délai, le microcalculateur 4 traite le nombre téléchargé au moyen d'un algorithme approprié et affiche soit un gain, soit un nombre qui devra être comparé avec le résultat d'un tirage effectué au cours d'émission pour déterminer si le joueur a gagné, cette comparaison pouvant être effectuée dans le microcalculateur 4 grâce à une deuxième séquence de téléchargement par l'intermédiaire des moyens de réception R.

Les scénarios de jeux envisageables sont extrêmement nombreux et ne sont pas l'objet de la présente invention. Celle-ci vise de manière générale à permettre à un individu, d'une part, de participer à une émission ou programme diffusé en entrant par le clavier de son dispositif une ou plusieurs données représentatives de sa participation, qu'il s'agisse d'une ou plusieurs réponses à une ou plusieurs questions posées, en début, en cours ou en fin d'émission, d'un ou plusieurs nombres aléatoires choisis par l'individu dans le cadre d'une loterie, de la mise d'un certain montant (argent, points), etc..., et, d'autre part, de valider le résultat de cette participation en liaison avec un serveur. Dans un but de simplification, l'invention sera plus particulièrement décrite ci-après dans son application à des jeux faisant appel à des enchaînements de questions et de réponses.

Les émissions ou programmes peuvent être diffusés sur des récepteurs de télévision par un réseau câblé ou hertzien, sur des terminaux télématiques (par exemple du type MINITEL), sur des terminaux d'ordinateurs, ou encore sur des récepteurs radiophoniques si le dispositif est équipé de moyens appropriés, tels que décrits par exemple dans le brevet US-A-4 745 468, pour le téléchargement du scénario.

Dans les modes particuliers de réalisation décrits en regard des figures, le dispositif 1 est pourvu de moyens de réception optique R et les données ou paramètres définissant le scénario qui permettra aux spectateurs de participer à un programme, ci-après également appelé jeu, sont transmises par une station émettrice E (figure 4) au début de celui-ci sous forme d'une image lumineuse variable telle qu'une mire p qui s'affiche en incrustation sur l'écran 15 d'un poste récepteur de télévision 16.

Ces données sont de préférence chiffrées et comprennent essentiellement les informations suivantes :

- la nature du jeu diffusé, correspondant à un programme stocké dans la mémoire ROM 11 du microcalculateur 4 ;
- le déroulement chronologique du "jeu", dont les paramètres sont :
  * les instants auxquels le dispositif prie le joueur de répondre aux questions ;
  * le temps alloué pour chaque réponse ;
- les réponses correctes aux questions posées ;
- éventuellement les gains attribués aux bonnes réponses, ces gains pouvant, en variante, être programmés dans le microcalculateur en fonction de la nature du jeu détecté.

A ces données sont associés des codes de contrôle de cohérence (CCC) et de détection d'erreurs (CRC) nécessaires pour assurer la sécurité, la fiabilité du jeu et la protection contre les fraudes.

La chronologie du scénario téléchargé est telle que, dans les dispositifs, le jeu se déroule en synchronisme avec le programme diffusé par la station émettrice.

Dans le cas où la quantité d'informations transmises aux dispositifs au cours d'une opération de téléchargement serait insuffisante pour contrôler le déroulement du jeu durant toute l'émission, plusieurs téléchargements peuvent être utilisés pendant le cours de l'émission.

Pour participer au jeu ou programme diffusé, le joueur doit tout d'abord télécharger dans son dispositif les données de scénario précitées transmises par la station émettrice E (figure 4). Suivant la quantité de données à transmettre, leur téléchargement dans un dispositif peut prendre une fraction de seconde à plusieurs secondes. Ce temps étant très court, il est nécessaire de répéter à l'écran les séquences de téléchargement pendant une période de temps suffisante, par exemple de quelques dizaines de secondes à plus d'une minute, pour assurer que les téléspectateurs ont bien pu télécharger dans leur dispositif le scénario du jeu à venir.

Par conséquent, certains dispositifs seront téléchargés au début de la période de téléchargement, d'autres à la fin de la période. Ces dispositifs présenteront un déphasage entre eux, alors que le processus requiert une bonne synchronisation entre le déroulement du scénario dans les dispositifs et le déroulement du programme diffusé.

Différentes solutions sont envisageables pour résoudre ce problème, la plus simple consistant à émettre dans chaque séquence de téléchargement une information représentative du retard de cette séquence par rapport à la séquence de téléchargement initiale. Cette information sera prise en compte par le microcalculateur 4 pour initialiser la temporisation du déroulement du scénario.

Un appui sur la touche "TELE" a pour effet de générer une interruption sélectionnant le programme de réception de données optiques du microcalculateur 4. Si le dispositif est équipé d'une fonction d'identification, l'individu doit au préalable le rendre actif en appuyant sur la touche "ID" puis en entrant au clavier 8 son code d'identification confidentiel (NID). En variante, l'interruption précitée peut être générée par une trame optique particulière précédant l'émission des données à télécharger.

Dès que la mire appropriée (pavés lumineux p) apparaît sur l'écran 15 (figure 4), l'utilisateur doit placer son dispositif contre celui-ci à l'endroit voulu. Les moyens de réception optique R convertissent les variations de luminosité de l'écran 15 en signaux électriques qui sont convertis en signaux binaires du format voulu par les moyens de traitement 5. Les données reçues sont décodées (déchiffrage) par le microcalculateur 4 qui, lorsqu'il a reçu toutes les données voulues, fait apparaître sur l'écran 7 de l'afficheur 6 un message, tel que "PRET", indiquant que le dispositif est prêt à fonctionner.

L'utilisateur n'a plus alors qu'à regarder l'émission jusqu'à ce que la première question soit posée, soit oralement, soit sous forme écrite en incrustation sur l'écran. Le délai imparti pour répondre peut être affiché sur l'écran sous forme d'un décomptage en secondes, et parallèlement le microcalculateur 4 peut inviter l'utilisateur à répondre en affichant une information sur l'écran, par exemple le signe "?".

L'utilisateur entre alors sa réponse au clavier et la confirme en appuyant sur la touche "ENT" et, à partir de cet instant, le microcalculateur 4 compte le temps qui s'écoule, cadencé par l'horloge 10, en vue d'une certification ultérieure du résultat ou score obtenu par l'utilisateur à la fin du jeu.

Celui-ci se poursuit en synchronisme avec le déroulement de l'émission, le joueur devant à chaque fois introduire sa réponse au clavier dans le délai fixé.

Le microcalculateur 4 compare chaque réponse introduite au clavier 8 avec la bonne réponse téléchargée et stockée dans la mémoire 12 et actualise le score du joueur en fonction de paramètres qui, soit ont été téléchargés, soit font partie du programme du microcalculateur relatif au jeu considéré. Le microcalculateur peut être programmé pour afficher sur l'écran 7 un message indiquant si le joueur a donné ou non la bonne réponse ("BRAVO", "DESOLE"), que cette bonne réponse soit donnée ou non à l'écran pendant ou à la fin de l'émission.

Le microcalculateur 4 peut également être programmé pour afficher sur l'écran 7 le score réalisé par le joueur à la fin du jeu, soit en nombre de bonnes réponses, soit en nombre de points ou sous toute autre forme appropriée. L'actionnement de la touche "CL" permet également, suivant la programmation du microcalculateur 4, l'affichage du score réalisé sur le dernier jeu ou sur plusieurs jeux cumulés.

En dehors de ses périodes de fonctionnement (calcul, traitement des touches du clavier, etc...), le microcalculateur 4 se place automatiquement en état de veille afin de diminuer la consommation d'énergie électrique. Cependant, comme indiqué précédemment, le microcalculateur est périodiquement réactivé par l'horloge 10, ce qui permet de comptabiliser le temps écoulé depuis l'introduction de la première réponse au jeu.

Lorsque l'utilisateur veut faire valider le gain ou résultat qu'il a obtenu en participant à ce jeu, il doit se mettre en relation avec un serveur habilité, pour la mise en oeuvre d'une double procédure de certification et d'authentification. Ce serveur est par exemple un ordinateur qui possède en mémoire les dates limites absolues d'événements de référence de programmes ou émissions pour lesquels des joueurs sont susceptibles de faire valider leur résultat. Ce serveur est également équipé d'une horloge synchrone de l'horloge 10 du dispositif 1 et permettant de calculer le temps écoulé entre la date absolue de l'un de ces événements et la date absolue à laquelle il est saisi par un joueur d'une demande de certification et d'authentification de son résultat pour le jeu considéré.

Dans une première forme de réalisation de l'invention qui sera décrite ci-après, les gains réalisés par l'utilisateur sont crédités dans le serveur S.

L'appel du serveur peut être réalisé de différentes manières, par exemple, par voie de communication téléphonique avec une opératrice du serveur ou par l'intermédiaire d'un terminal informatique ou télématique conventionnel ou d'un terminal spécifique connecté au serveur. Suivant les cas, la demande de certification et d'authentification peut être transmise au microcalculateur 4 par l'intermédiaire du clavier 8 ou des moyens de réception optiques R.

Si le serveur est susceptible, à un instant donné, de valider les résultats obtenus à plusieurs jeux différents, il pourra être prévu que le joueur indique au serveur un code, par exemple un numéro, identifiant le jeu pour lequel il souhaite faire valider son résultat.

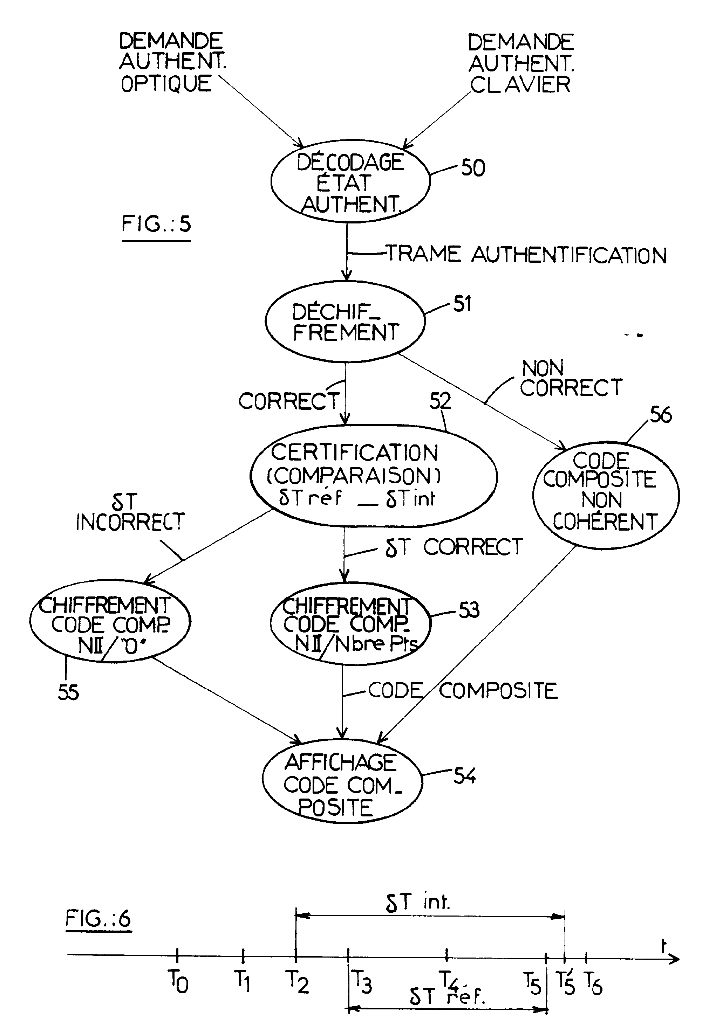

Parallèlement, son dispositif 1 devra, après avoir éventuellement été rendu actif par la procédure d'identification, être mis en état de recevoir la demande de certification et d'authentification, soit par appui sur la touche "ID" si la demande est transmise sous forme d'un code numérique par l'intermédiaire du clavier, soit par appui sur la touche "TELE" ou par réception d'une trame optique particulière si la demande est transmise aux moyens de réception R sous forme optique : cet état est décodé par le microcalculateur 4 (étape 50, figure 5).

La demande reçue du serveur (trame optique ou code numérique transmis par une opératrice ou affiché sur l'écran d'un terminal) à l'initiative du joueur est un code chiffré et comportant les informations suivantes :
- un numéro identifiant le jeu ;
- une valeur $\delta T_{ref}$ qui représente l'écart temporel entre la fin du délai de réponse à la première question posée (date limite) et le moment de la transmission par le serveur de la demande de certification et d'authentification ;
- un nombre aléatoire ou aléa.

Ce code est transmis au microcalculateur 4 (moyens de réception R ou clavier 8) qui en assure le déchiffrement 51 à l'aide d'un algorithme implanté dans la mémoire ROM 11.

Si le chiffrement est correct, le microcalculateur 4 compare la valeur $\delta T_{ref}$ reçue du serveur avec la valeur $\delta T_{int}$ représentant le temps mesuré entre l'instant d'introduction de la réponse à la première question du jeu considéré et l'instant de réception par le microcalculateur de la demande de certification et l'authentification (étape 52).

Si l'écart entre ces valeurs est inférieur à une tolérance définie $\pm\tau$, le gain ou résultat du jeu est certifié et le microcalculateur 4 émet un code composite (étape 53) par codage, suivant un algorithme donné, en fonction du nombre aléatoire transmis par le serveur, du résultat ou gain certifié et d'un code d'identification interne (NII) chargé dans la mémoire de stockage 12 lors de la personnalisation du dispositif.

Ce code composite est affiché sur l'afficheur 6 (étape 54) sous forme alphanumérique afin d'être transmis au serveur (par voie téléphonique, introduction au clavier d'un terminal ou lecture par un terminal ou borne spécifique comme décrit par exemple dans la demande de brevet français FR-A- 2 650 416 en vue d'une poursuite de la procédure d'authentification qui sera décrite plus en détails ci-après. En variante, ce code composite peut être transmis au serveur par les moyens de transmission 14 si le dispositif en est équipé. Son affichage sur l'écran 7 peut alors être omis.

Si, à l'étape 52, l'écart entre $\delta T_{int}$ et $\delta T_{ref}$ n'est pas correct, le microcalculateur émet un code composite avec l'information gain ou résultat nul (étape 55) et affiche ce code (étape 54).

Enfin, pour tout autre type d'erreur telle que la détection d'un chiffrement incorrect à l'étape 51, le microcalculateur émet un code composite non cohérent (données aléatoires) pour se protéger contre la fraude (étape 56) et affiche ce code non cohérent (étape 54).

Le nombre total de codes composites par jour peut être limité : au-delà d'un nombre défini, le dispositif émet un code composite non cohérent afin de se prémunir contre la fraude (essais successifs).

De plus, l'écart temporel entre la fin d'un jeu et la demande de certification et d'authentification doit être de préférence limité, par exemple à une demi-journée, afin de tenir compte des dérives possibles des horloges des différents dispositifs en service. Une durée de cet ordre est suffisamment faible pour que les écarts entre les différentes horloges restent dans une fourchette acceptable.

On a représenté à la figure 6, sous forme d'un diagramme des temps, les étapes séparant le début d'un jeu de la demande de certification et d'authentification. Sur cette figure :
- $T_0$ représente la date absolue de début du jeu, c'est-à-dire la fin de la première des séquences successives de téléchargement initial ;
- $T_1$ est la date absolue à laquelle la première question a été posée ;
- $T_2$ est la date absolue à laquelle le joueur a introduit dans son dispositif la réponse à la première question ;
- $T_3$ est la date limite absolue de réponse à la première question ;
- $T_4$ est la date absolue à laquelle la réponse à la première question a été donnée à l'écran ;
- $T_5$ est la date absolue à laquelle le serveur, saisi d'une demande de certification et d'authentification, transmet celle-ci ;
- $T'_5$ est la date absolue à laquelle le microcalculateur 4 reçoit la demande de certification et d'authentification en provenance du serveur ;
- $T_6$ est la date absolue d'introduction dans le serveur du code composite élaboré par le dispositif 1.
- $\delta T_{int}$ est le temps relatif calculé par le microcalculateur 4 entre la date absolue $T_2$ d'introduc-

tion de la réponse à la première question et la date absolue $T'_5$ de réception par celui-ci de la demande de certification et d'authentification ;

- $\delta T_{ref}$ est le temps relatif, calculé par le serveur, entre la date limite absolue $T_3$ de réponse à la première question et la date absolue $T_5$ de transmission par le serveur d'une demande de certification et d'authentification.

Dans le présent mémoire, on entend par "date" la position d'un événement sur une échelle de temps absolu d'origine définie, par exemple le calendrier usuel. On supposera que les temps, et par conséquent les "dates", sont mesurés au dixième de seconde près.

Il résulte de ce qui précède que :

$$\delta T_{int} = T'_5 - T_2$$

Si, en première approximation, on considère que $T_5$ et $T'_5$ sont confondus, la date absolue $T_2$, qui est la seule variable inconnue, est égale à :

$$T_2 = T_5 - \delta T_{int}$$

Par conséquent, bien que le dispositif 1 ne mesure que des temps relatifs, grâce à l'heure absolue $T_5$ fournie par le serveur il est possible de connaître l'heure absolue $T_2$ de réponse du joueur à la première question (c'est-à-dire de dater cet événement) et de vérifier si cette réponse a bien été faite avant l'heure absolue $T_3$ à laquelle la bonne réponse a été donnée à l'écran.

Il est à noter que le point de départ de $\delta T_{int}$ n'est pas nécessairement celui de la réponse à la première question: il peut s'agir de la réponse à la n$^{ième}$ question puisque la chronologie du scénario de déroulement du jeu est figée par les données téléchargées. Dans ce cas, le point de départ de $\delta T_{ref}$ sera la fin du délai de réponse à la n$^{ième}$ question. En variante $\delta T_{int}$ peut être mesuré ou calculé à partir d'un événement prédéterminé du scénario, par exemple $T_0$, $T_1$, $T_3$ etc...

En pratique, le serveur calcule $\delta T_{ref}$, le transmet au dispositif comme indiqué précédemment et le microcalculateur 4 compare $\delta T_{int}$ et $\delta T_{ref}$.

En variante, la valeur $\delta T_{int}$ et le résultat calculés par le microcalculateur 4 peuvent être transmis du dispositif 1 au serveur qui effectue la comparaison entre $\delta T_{int}$ et $\delta T_{ref}$ et certifie ou non le résultat.

Toutefois, dans l'un ou l'autre cas, la certification du résultat résulte de la mesure, par le microcalculateur 4 et l'horloge 10, du "certificat" que constitue le temps $\delta T_{int}$.

Le résultat est certifié si l'écart entre $\delta T_{ref}$ et $\delta T_{int}$ est inférieur à une tolérance définie $\tau$. Cette tolérance $\tau$ est fixée en fonction de la dérive maximale prévisible des horloges des dispositifs sur le délai maximal imparti pour faire valider un résultat (une demi-journée par exemple), de la précision sur la mesure des temps et du délai maximal autorisé entre la date $T_5$ de fourniture par le serveur des données (code jeu, $\delta T_{ref}$, nombre aléatoire) et la date $T'_5$ d'entrée du code composite dans le serveur.

Dans le cas où le code composite est introduit par le clavier du dispositif, le délai admissible doit être important, de l'ordre de plusieurs dizaines de secondes, afin de laisser aux utilisateurs le temps d'effectuer les opérations nécessaires. Le microcalculateur 4 arrête son calcul du temps $\delta T_{int}$ à la date $T'_5$ postérieure à la date $T_5$. Un délai maximal $T_6$-$T_5$ sera imparti au serveur pour accepter le code composite associé aux données fournies au dispositif.

La tolérance globale $\tau$ devra tenir compte des paramètres précités tout en étant inférieure à $T_4$ - $T_3$, c'est-à-dire au temps séparant la date limite de fourniture d'une réponse par les joueurs de la date de fourniture de la bonne réponse à l'écran.

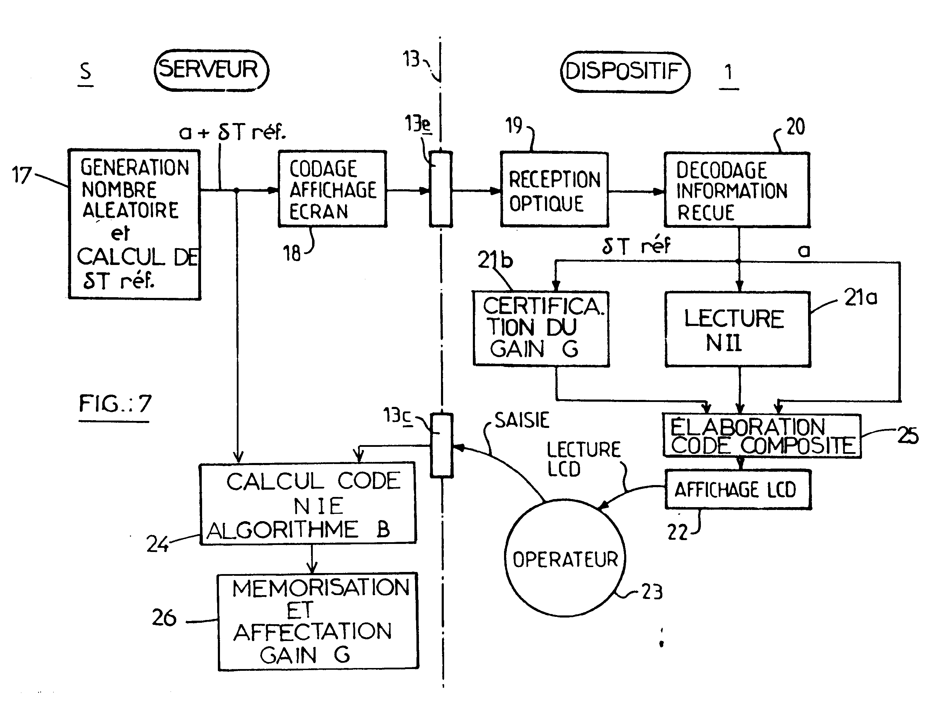

La figure 7 est un schéma fonctionnel illustrant la mise en oeuvre par voie optique du processus de certification et d'authentification de la figure 5. La partie gauche de cette figure correspond à l'automate de communication du serveur S. La partie située à droite du trait mixte (lequel schématise un terminal 13 du serveur S) correspond au dispositif 1.

Le bloc 17 correspond à la génération d'un nombre aléatoire $\underline{a}$ et au calcul du temps $\delta T_{ref}$ par le serveur S. Le bloc 18 correspond au codage et à l'affichage de ces données sur l'écran 13e du terminal. Le bloc 19 correspond à la réception optique des données par les phototransistors 3 du dispositif 1. Le bloc 20 correspond au décodage, par le microcalculateur 4, des données reçues. Le bloc 21a correspond à la lecture par le microcalculateur 4 du code NII et le bloc 21b à la certification du résultat G (comparaison $\delta T_{int}$, $\delta T_{ref}$). Le bloc 25 correspond au calcul par le microcalculateur 4 d'un code composite $\underline{x}$ à partir du code NII, du résultat G, du temps $\delta T_{ref}$ et du nombre aléatoire reçu $\underline{a}$, suivant un algorithme A. Le bloc 22 correspond à l'affichage sur l'écran 7 du dispositif 1 du code composite $\underline{x}$ calculé en 25.

L'utilisateur, schématisé par un cercle 23, après lecture sur l'écran 7, introduit sur le clavier 13c du terminal 13 le code affiché $\underline{x}$ sur l'écran 7.

Le bloc 24 correspond, dans le serveur S, à un calcul effectué, au moyen du nombre aléatoire $\underline{a}$ suivant un algorithme B corrélé à l'algorithme A, sur le code composite $\underline{x}$ pour décoder le résultat G et calculer un code d'identification externe NIE, le résultat G étant validé lorsqu'il y a cohérence du code d'identification externe NIE avec une information de contrôle connue du serveur. Si l'algorithme B est symétrique de l'algorithme A, les codes NIE et NII sont égaux en cas de cohérence.

Si la cohérence est établie, le résultat ou gain G ainsi validé est stocké en mémoire par le serveur et affecté au possesseur du dispositif, lequel est identifié, par exemple, par le code NIE (bloc 26). En cas d'absence de cohérence, le résultat n'est pas affecté.

La cohérence peut être établie, par exemple, par traitement sur le code NIE, en fonction de règles de codage prédéterminées, et/ou par corrélation du code NIE avec une information externe entrée par l'utilisateur dans le serveur, par exemple le numéro de série de la carte, le nom de l'utilisateur, un mot de passe, etc...

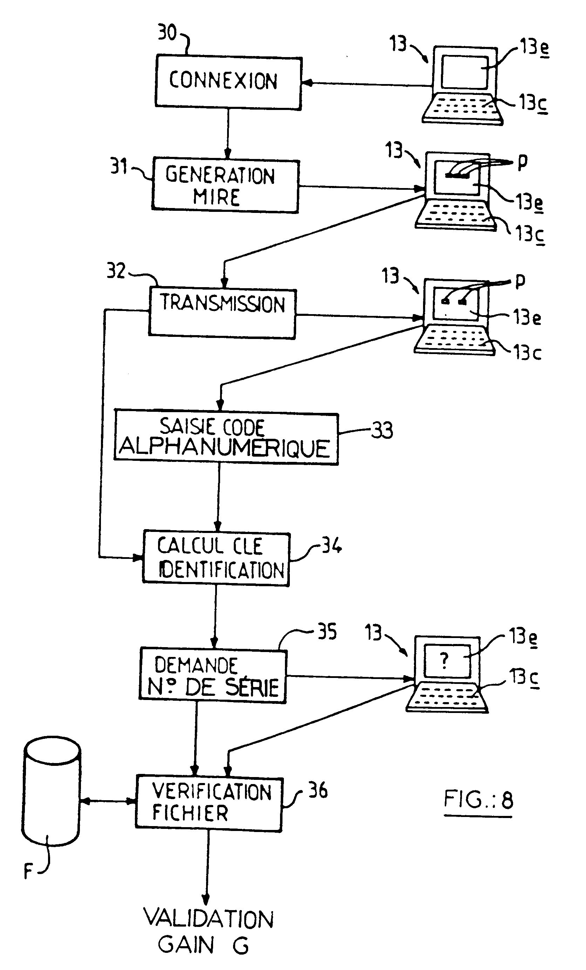

La figure 8 est un schéma illustrant le déroulement du processus de certification et d'authentification à l'aide du dispositif 1 de l'invention, en liaison avec un serveur S pourvu d'un terminal 13 à écran et clavier. Cette figure 8 explicite certaines des fonctions décrites à propos de la figure 7.

L'opérateur, à partir du terminal 13, transmet tout d'abord au serveur S sa demande d'accès puis de validation d'un gain à un jeu donné en tapant, sur le clavier 13c du terminal 13, les informations voulues. Le bloc 30 correspond a l'établissement de la connexion avec le serveur S qui génère une mire (bloc 31) c'est-à-dire fait apparaître sur l'écran 13e du terminal des pavés lumineux p qui, dans l'exemple représenté, sont constitués par trois rectangles alignés.

L'opérateur présente alors le dispositif 1 de manière à placer les phototransistors 3 en face des pavés p et appuie sur la touche "TELE" du clavier 8. Le dispositif 1 est en place pour recevoir des informations par voie optique.

L'utilisateur appuie alors sur une touche du clavier 13c du terminal. Le serveur S, en réponse à l'enfoncement de la touche du clavier 13c, génère et transmet, au terminal 13, sous forme codée, le nombre aléatoire, le numéro du jeu et le temps $\delta T_{ref}$, comme indiqué par le bloc 32. Les informations correspondantes se traduisent sur l'écran 13e par des variations de niveaux de luminosité des pavés p, informations qui sont reçues par le dispositif 1. Ce dernier certifie ou non le résultat G et fait apparaître sur l'écran 8 un code composite alphabétique et/ou numérique que l'utilisateur introduit sur le clavier 13c, ce qui correspond au bloc 33 de saisie par le serveur S.

Le bloc 34 correspond au calcul, par le serveur S, d'un code identifiant le dispositif, à partir du nombre aléatoire généré en 32 et du code composite introduit au clavier 13c.

Le serveur demande alors à l'opérateur de taper sur le clavier 13c le numéro de série figurant sur le dispositif en sa possession (étape 35). Le serveur S vérifie dans un fichier F, comme indiqué par le bloc 36, la concordance entre le numéro de série et le numéro ou code NIE calculé par le bloc 34. Lorsque la cohérence est établie, le gain G est validé et il est affecté à l'utilisateur dans une mémoire du serveur, par exemple en demandant à celui-ci de s'identifier sur le terminal 13c.

Dans le mode de réalisation qui vient d'être décrit, les résultats ou gains obtenus par les participants sont gérés de manière centralisée au niveau du serveur.

Une telle gestion est relativement lourde et, suivant les applications, il peut s'avérer plus avantageux de créditer les gains obtenus par un individu directement dans son dispositif.

Cette solution offre l'avantage, lorsque le dispositif est portable, que son titulaire peut exploiter aisément le crédit dont il dispose, soit pour participer à de nouveaux jeux, soit en tout lieu (point de vente par exemple) équipé d'une borne ou terminal capable d'authentifier le dispositif et de lire et débiter la mémoire protégée de crédit. Cette borne ou terminal n'est pas nécessairement connecté au serveur si le gain crédité dans le dispositif a été préalablement validé.

Pour des raisons de sécurité, il peut être alors préférable que le gain soit crédité, à l'intérieur du dispositif, dans une partie de sa mémoire 12 constituée par une mémoire protégée conventionnelle du type que l'on rencontre, par exemple, dans le domaine des cartes à microcircuit. De telles cartes à mémoires protégées sont décrites, par exemple, dans l'ouvrage intitulé "Les cartes à microcircuit" de F. Guez et C. Robert publié en 1988 chez MASSON (France).

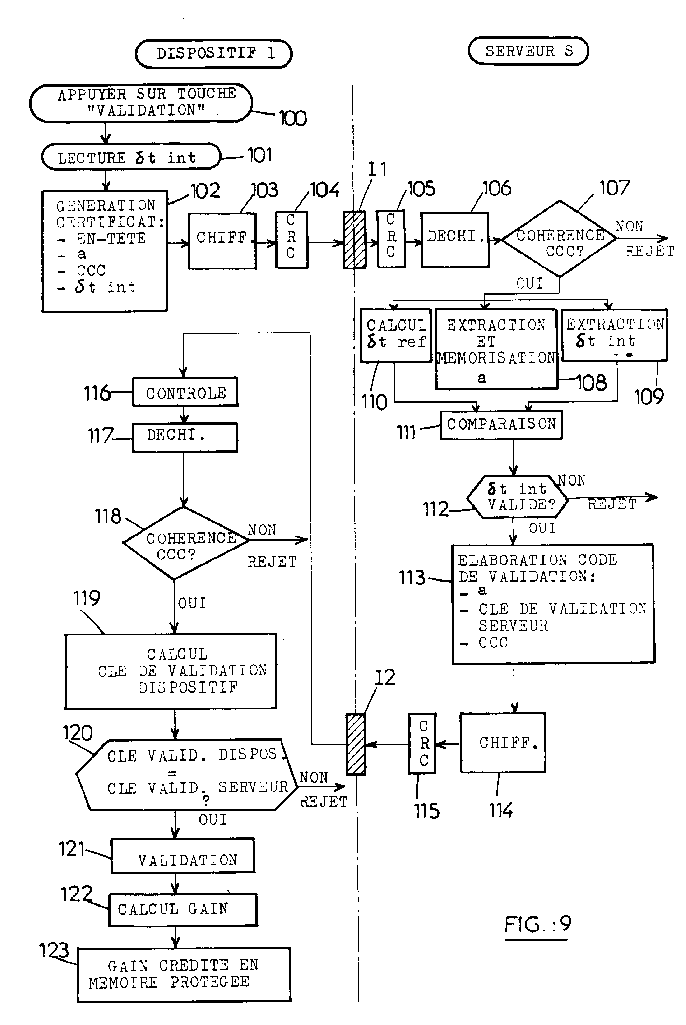

Une seconde forme préférée de réalisation de l'invention sera décrite en regard de la figure 9, qui illustre un processus de certification et d'authentification de résultat crédité dans le dispositif 1.

Sur cette figure, la partie située à droite du trait mixte correspond à un automate de communication du serveur S. La partie située à gauche du trait mixte (lequel schématise la ou les interfaces entre le dispositif et le serveur S) illustre les fonctions mises en oeuvre par le dispositif 1, lequel est supposé portable.

Le titulaire du dispositif 1, ci-après également appelé le joueur, est supposé avoir participé à un programme (pari, loterie, jeu interactif...) comme décrit précédemment et obtenu un certain gain qu'il veut faire valider dans son dispositif.

Pour ce faire, la procédure de validation doit être déclenchée dans le dispositif 1 par actionnement d'une touche ou d'une combinaison de touches du clavier 8 (étape 100). De préférence, le dispositif comporte une touche "validation" (non représentée), remplaçant par exemple la touche "ID" décrite précédemment. Le déclenchement du processus de certification et d'authentification peut être subordonné ou non, après l'actionnement de la touche "validation", à l'entrée par l'utilisateur d'un code confidentiel d'identification.

L'actionnement de la touche "validation", suivi ou non de l'entrée du code confidentiel d'identification, génère dans le microcalculateur une interruption ayant pour effet d'entamer le déroulement d'un programme de certification et d'authentification. A la première étape 101 de ce programme le microcalculateur détermine le temps relatif $\delta T_{int}$ qui s'est écoulé entre la date absolue de l'événement caractéristique de la participation du joueur au programme (pari, réponse à une question, etc...) et la date absolue à laquelle le processus de certification et d'authentification a été déclenché comme décrit ci-dessus.

Le microcalculateur génère ensuite un certificat (étape 102) comprenant :

- une en-tête, à savoir des données de formatage du certificat ;
- une donnée secrète $a$, qui peut être par exemple un nombre aléatoire ou pseudo-aléatoire engendré par le microcalculateur, dont le rôle sera explicité dans la suite ;
- le temps $\delta T_{int}$ ;
- un code de contrôle de cohérence CCC.

Le certificat peut également comporter d'autres informations telles que le code d'identification interne NII du dispositif afin de parfaire son authentification par le serveur, le gain G contenu dans le dispositif, etc...

Le certificat est ensuite chiffré à l'étape 103 au moyen d'une clé variable connue du serveur S, clé qui peut être calculée par exemple à partir de la date en cours et/ou d'une information variable faisant partie des données téléchargées dans le dispositif pour la participation au programme. Un code de contrôle d'erreur CRC est ensuite associé au certificat chiffré à l'étape 104. Ainsi le certificat transmis au serveur varie avec chaque programme (jeu, pari, etc...) et à chaque opération de validation.

Le certificat chiffré est transmis au serveur S par des moyens appropriés symbolisés sous forme d'une interface $I_1$. Si la longueur du certificat le permet, le certificat chiffré sera affiché sous forme alphanumérique sur l'écran 7 du dispositif et introduit dans le serveur, soit par le joueur sur le clavier d'un terminal, soit par une opératrice en liaison téléphonique avec le joueur, soit par tout autre moyen approprié. En variante, le certificat chiffré peut être transmis au serveur par une liaison numérique entre le dispositif et le terminal du serveur, par exemple du type modem acoustique, le dispositif comportant alors un transducteur acoustique conventionnel.

A l'étape 105, le serveur S procède à un contrôle du certificat reçu au moyen du code de contrôle d'erreur CRC que comporte ce certificat. L'étape suivante 106 consiste à déchiffrer le certificat et l'étape 107 est un test opéré sur le certificat pour en vérifier la cohérence en fonction du code de contrôle de cohérence CCC qu'il comporte.

Si le certificat reçu est jugé non cohérent il est rejeté. Dans le cas contraire, le serveur S extrait du certificat l'information secrète $a$ (étape 108) et le temps $\delta T_{int}$(étape 109) et calcule le temps $\delta T_{ref}$ (étape 110).

L'étape suivante 111 est une comparaison entre les temps $\delta T_{int}$ et $\delta T_{ref}$. Suivant que l'écart entre $\delta T_{ref}$ et $\delta T_{int}$ est inférieur ou supérieur à une tolérance définie, la procédure de validation en cours est poursuivie ou rejetée (étape 112).

A ce stade, ou à d'autres moments du déroulement de la procédure de validation dans le serveur, ce dernier peut procéder à d'autres opérations telles que le contrôle du numéro d'identification interne NII ou la mémorisation du gain si le certificat contient de telles informations.

Si la réponse au test 112 est positive, le serveur procède en 113 à l'élaboration d'un code de validation contenant une clé de validation destinée à être reconnue par le dispositif. Cette clé de validation peut être fixe mais elle est de préférence variable : par exemple, elle peut être fonction d'une donnée fournie au dispositif lors du téléchargement du programme qui a généré le gain en cours de validation, elle peut être fonction de la date instantanée, etc...

Le code de validation peut également contenir d'autres informations liées à l'exploitation du dispositif, par exemple le montant du gain qui sera affecté dans le dispositif à l'utilisateur, une règle pour le calcul de ce gain dans le dispositif, etc...

A la clé de validation est associé un code de contrôle de cohérence CCC et l'ensemble est chiffré à l'étape 114 au moyen de l'information secrète $a$, laquelle peut également faire partie du code de validation. A l'étape 115 un code de contrôle d'erreur CRC est associé au code de validation chiffré.

Ce code est transmis au dispositif 1 par des moyens symbolisés par une interface $I_2$ qui peut consister, soit en l'affichage ou la transmission par une opératrice de ce code sous forme de caractères alphanumériques que l'utilisateur n'a plus qu'à introduire dans son dispositif au moyen du clavier 8, soit en une liaison numérique de type acoustique, lumineuse ou autre. Le code de validation chiffré peut par exemple être transmis du serveur S au dispositif 1 par génération d'une séquence lumineuse susceptible d'être lue par les phototransistors 3 dont est muni le dispositif.

A l'étape 116, le microcalculateur du dispositif procède à un contrôle du message reçu en fonction du code de contrôle d'erreur CRC associé à celui-ci et procède ensuite au déchiffrement du code de validation en fonction de l'information secrète $a$ que le microcalculateur connaît puisqu'elle a été générée et mémorisée par celui-ci. Les opérations de chiffrement et déchiffrement mises en oeuvre aux étapes 103, 106, 114 et 117 font appel à des logiciels conventionnels bien connus des spécialistes de cette technique.

La cohérence du code de validation est testée à l'étape 118 en fonction du code de contrôle de cohérence CCC associé et, en cas de défaut de cohérence, la procédure de validation en cours est rejetée.

Dans le cas contraire, le microcalculateur procède en 119 au calcul de la clé de validation à partir du même paramètre (par exemple date instantanée, information fournie au dispositif lors du téléchargement du programme, etc...) que celle qui a servi au serveur pour calculer la clé de validation transmise au dispositif.

Le microcalculateur du dispositif procède en 120 à un test pour déterminer si les clés de validation calculées d'une part par le serveur, d'autre part par le dispositif, sont égales ou cohérentes. Dans la négative, la procédure de validation en cours est rejetée, dans le cas contraire, la participation au jeu est validée en 121, le gain qui en est issu est calculé en 122 et le montant de ce gain est crédité en 123 dans la mémoire protégée dont est équipé le dispositif.

Selon cette forme préférée de réalisation de l'invention, le gain est crédité directement dans le dispositif au moyen duquel il a été obtenu, mais la certification que ce gain a bien été réalisé en jouant avec le dispositif avant une heure limite autorisée est effectuée dans le serveur.

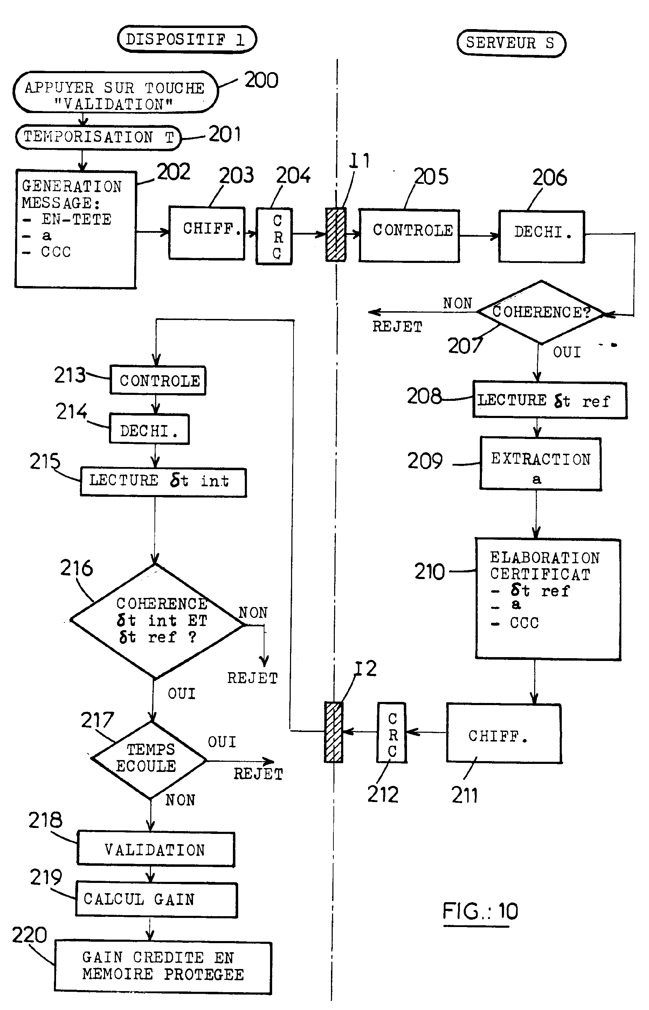

En variante, selon une troisième forme de réalisation de l'invention, la certification peut être opérée et le gain peut être crédité directement dans le dispositif 1 comme représenté à la figure 10 à laquelle on se reportera.

Comme dans le cas de la figure 9, le processus de validation est déclenché par l'actionnement d'une touche "validation" ou d'une combinaison de plusieurs touches (étape 200). Cette action a pour effet de déclencher une temporisation (étape 201) pour mesurer le temps qui s'écoule entre le début de la procédure de validation et la réception par le dispositif d'un certificat émis par le serveur comme cela sera décrit dans la suite.

A l'étape 202, le microcalculateur engendre un message analogue à celui de l'étape 102 de la figure 9, hormis le fait que ce message ne contient pas le temps $\delta T_{int}$. Le message élaboré à l'étape 202 est chiffré en 203 comme décrit à propos de l'étape 103, puis affecté d'un code de contrôle d'erreur CRC en 204.

Ce message est alors transmis au serveur S par l'intermédiaire de l'interface $I_1$ comme décrit à propos de la figure 9.

Dans le serveur S, un contrôle d'erreur est effectué en 205 au moyen du code CRC et le message est déchiffré en 206. La cohérence du message déchiffré est testée à l'étape 207 au moyen du code de contrôle de cohérence CCC contenu dans le message. Si le message n'apparaît pas cohérent, la procédure de validation en cours est abandonnée.

Dans le cas contraire, le serveur S détermine à l'étape 208 le temps $\delta T_{ref}$ qui s'est écoulé entre la date limite de participation au programme (date qui est naturellement connue du serveur) et la date instantanée, c'est-à-dire la date à laquelle le serveur est saisi d'un message cohérent représentatif d'une demande de validation.

Après cette étape 208, le serveur procède en 209 à l'extraction de l'information secrète a du message reçu et élabore en 210 un certificat contenant le temps $\delta T_{ref}$ obtenu à l'étape 208.

De même que pour le code de validation élaboré à l'étape 113 de la figure 9, le certificat de l'étape 210, outre un code de contrôle de cohérence CCC, peut contenir d'autres informations (montant du gain, règle de calcul du gain, etc...) liées à l'exploitation du dispositif. Le serveur peut également procéder à une authentification du dispositif sur la base, par exemple, du numéro d'identification interne NII de celui-ci, s'il est contenu dans le message transmis du dispositif au serveur. Par contre, dans ce second mode de réalisation, le gain ne peut pas, à ce stade, être mémorisé dans le serveur à des fins statistiques ou de contrôle comme dans le cas de la figure 9, car la certification n'intervient pas dans le serveur mais, dans un deuxième stade, dans le dispositif.

Le certificat élaboré à l'étape 210 est chiffré en 211 au moyen de l'information secrète a (information qui peut faire partie ou non du certificat), puis le certificat chiffré est doté en 212 d'un code de contrôle d'erreur CRC. Le certificat chiffré est transmis au dispositif 1 par les moyens d'interface $I_2$ qui ont été décrits à propos de la figure 9.

Le microcalculateur du dispositif procède en 213 au contrôle du certificat au moyen du code CRC, à son déchiffrement en 214 au moyen de l'information secrète a élaborée à l'étape 202 et mémorisée par le microcalculateur, et détermine en 215 le temps $\delta T_{int}$.

L'étape suivante 216 est un test permettant de déterminer s'il y a cohérence entre le temps $\delta T_{int}$ mesuré dans le dispositif et le temps $\delta T_{ref}$ élaboré par le serveur. Dans la négative, la procédure de validation en cours est rejetée.

Dans l'affirmative, le microcalculateur examine en 217 si le temps qui s'est écoulé depuis le déclenchement de la temporisation à l'étape 201 est supérieur ou non à une durée prédéterminée mémorisée dans le microcalculateur. Cette temporisation et ce test ont pour but d'empêcher les fraudes qui pourraient consister, après l'étape 212, à retarder l'introduction dans le dispositif du certificat élaboré par le serveur et à augmenter ainsi artificiellement le temps $\delta T_{int}$. Si le temps écoulé depuis le déclenchement de la temporisation en 201 est supérieur à la durée prédéterminée précitée, la procédure de validation est abandonnée.

Dans le cas contraire, le microcalculateur valide en 218 la participation au programme, calcule le gain obtenu en 219 et le crédite dans la mémoire protégée réservée à cet effet en 220.

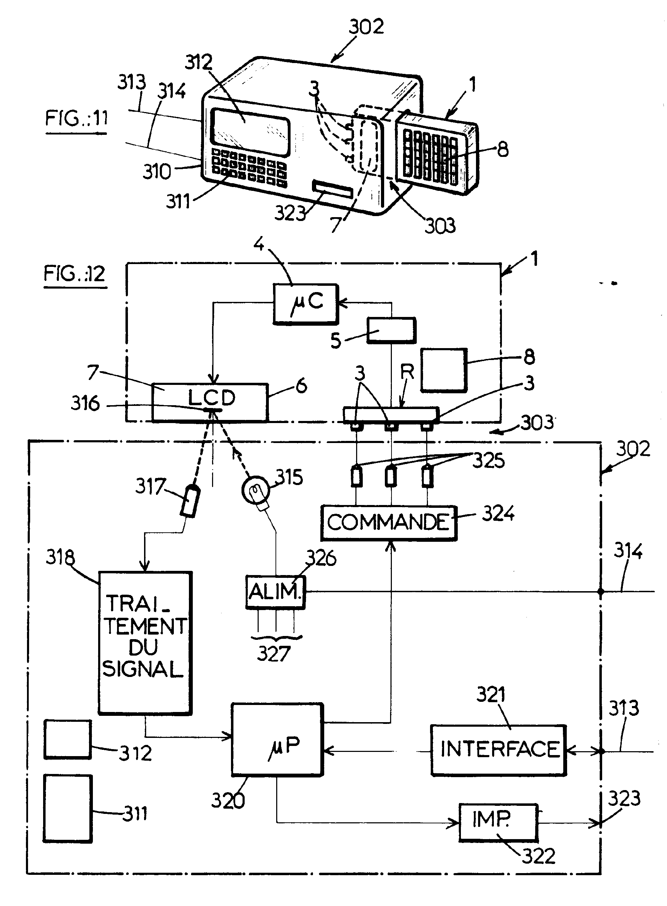

Lorsque le joueur veut utiliser le gain mémorisé dans son dispositif portatif, il doit établir une liaison avec une borne ou terminal autonome ou connecté au serveur S, selon une procédure similaire à celle décrite en regard de la figure 8, afin de débiter la mémoire de son dispositif de tout ou partie du gain et d'obtenir une contrepartie sous forme, par exemple, de bon, ticket ou autre support. Ce terminal peut être un terminal à écran et clavier conventionnel ou, par exemple, un terminal spécifique tel que la borne décrite en regard des figures 11 et 12.

Une telle borne fait l'objet de la demande de brevet français FR-A-2 650 416 à laquelle on pourra se reporter. Cette borne 302 comprend, dans un boîtier 310, outre un poste de réception 303 du dispositif portatif 1, un clavier 311 et un écran 312 de tout type connu, qui sont des organes classiquement disposés sur tout terminal informatique pour l'entrée et l'affichage de données. Une ligne 313 raccorde éventuellement la borne 302 au serveur S. Une autre ligne 314 assure l'alimentation électrique de la borne par le secteur.

Le poste de réception 303 comprend des moyens de lecture optique constitués par une source lumineuse 315 pour éclairer une plage 316 de l'écran 7 du dispositif 1 (une diode électroluminescente ou LED, par exemple) et un capteur photosensible 317 (un phototransistor par exemple), directionnel de préférence, orienté vers cette plage suivant une direction choisie. La source lumineuse peut être alimentée électriquement à partir du secteur par la ligne 314, à travers un circuit d'alimentation 326 qui produit également des tensions d'alimentation des autres organes et circuits de la borne, tensions délivrées sur les lignes de sortie 327. En modulant électriquement la réflectance de la plage 316, comme on le fait classiquement pour faire apparaître des caractères de couleur foncée sur un fond clair dans un afficheur à cristaux liquides, on module la quantité de lumière réfléchie par la plage 316 sur l'axe du capteur optique 317, qui produit alors un signal électrique modulé comme la réflectance de la plage 316. Après filtrage et mise en forme (dans un bloc de traitement de signal 318) de ce signal, on dispose d'un signal numérique qui entre dans des moyens de traitement d'informations 320, un microprocesseur par exemple, disposés dans la borne 302. L'information numérique ainsi reçue par le microprocesseur 320 est alors conforme à celle émise par le dispositif portatif 1 et transmise grâce à l'écran 7 à cristaux liquides, normalement utilisé à d'autres fins.

La borne 302 comprend également des moyens de transmission optique d'informations 325 coopérant avec les moyens de réception optique R du dispositif 1. Ces moyens de transmission optique 325 sont de préférence constitués par plusieurs organes photoémetteurs, tels que des diodes électroluminescentes, disposés dans le poste de réception 303 de manière à se trouver alignés chacun avec un phototransistor 3 du dispositif 1 lorsque celui-ci est engagé dans le poste de réception 303. Les organes photoémetteurs 325 sont pilotés par le microprocesseur 320 par l'intermédiaire d'un circuit de commande 324.

Les informations que le microprocesseur 320 transmet au dispositif 1 peuvent concerner par exemple le type d'informations que le microcalculateur 4 du dispositif 1 doit transférer à la borne 302.

Le microprocesseur 320 alimenté par l'information ainsi reçue, relative au gain d'un joueur, peut déclencher des actions telles que la délivrance en 323 d'un ticket par une imprimante 322 incorporée au lecteur, le ticket portant des informations permettant au joueur de faire valoir ces gains, et l'émission par les organes photoémetteurs 325 d'un accusé de réception en réponse auquel le microcalculateur 4 décrémente de la mémoire du dispositif 1 le montant du gain qui a été crédité au joueur. Les échanges d'informations entre le dispositif 1 et la borne 302 sont de préférence chiffrés de manière similaire à celle décrite précédemment à propos des processus de certification et d'authentification.

L'information numérique reçue par le microprocesseur 320 peut aussi être formatée et conformée dans une interface 321 avant d'être injectée sur la ligne 313 pour être transmise au serveur. Cette borne 302 peut donc avantageusement être utilisée comme terminal de serveur pour la mise en oeuvre des processus de certification et d'authentification décrits précédemment.

Cette borne permet un échange bidirectionnel automatique d'informations, donc dépourvu des erreurs et des délais qu'implique la transcription manuelle d'une information sur un clavier par un utilisateur (ce qui contribue à améliorer la fiabilité du processus de certification et d'authentification lorsque la borne est utilisée à cet effet), sans que cette possibilité supplémentaire n'alourdisse le prix de revient de fabrication du dispositif portatif 1, qui doit être aussi bas que possible. Bien sur le microcalculateur 4 présent dans l'objet portatif doit être dûment programmé suivant un protocole spécialisé assurant la commande de la réflectance de la plage 316 conformément à l'information à transmettre.

Il va de soi que les modes de réalisation décrits ne sont que des exemples et l'on pourrait les modifier, notamment par substitution d'équivalents techniques, sans sortir pour cela du cadre de l'invention.

## Revendications

1. système de participation d'au moins un individu à un programme télédiffusé, selon un scénario mémorisé dans un dispositif électronique individuel et autonome de participation, et de certification de ladite participation en liaison avec un serveur, ledit dispositif comprenant :
    - des moyens d'interface pour l'introduction par un participant d'au moins une donnée représentative de ladite participation audit programme et l'établissement d'une liaison de certification avec ledit serveur,
    - des moyens de mémorisation de ladite donnée de participation et dudit scénario, et
    - une horloge,
    caractérisé en ce que :
    - le dispositif (1) comprend des moyens (4, 10) pour mesurer le temps relatif ($\delta T_{int}$) écoulé entre au moins un premier événement dudit scénario corrélé chronologiquement à ladite introduction d'une donnée de participation dans le dispositif et l'établissement de ladite liaison de certification avec le serveur (S),

- le serveur (S) comprend des moyens (110, 208) pour mesurer le temps relatif ($\delta T_{ref}$) écoulé entre au moins un second événement dudit programme corrélé chronologiquement à une date limite absolue d'introduction de ladite donnée de participation et l'établissement de ladite liaison de certification, et

- le dispositif et/ou le serveur comporte(nt) des moyens (111, 216) pour comparer les temps relatifs mesurés dans le dispositif et le serveur et certifier ou non ladite participation en fonction du résultat de ladite comparaison.

2. Système selon la revendication 1, caractérisé en ce que ledit premier événement est constitué par ladite introduction d'une donnée de participation dans le dispositif.

3. Système selon l'une quelconque des revendications 1 et 2, caractérisé en ce que ledit second événement est constitué par ladite date limite absolue d'introduction d'une donnée de participation dans le dispositif.

4. Système selon l'une quelconque des revendications 1 à 3, caractérisé en ce que ledit scénario comprend des paramètres représentatifs du déroulement chronologique dudit programme et en ce que ledit dispositif comprend des moyens de temporisation pour la mise en oeuvre dudit scénario selon ladite chronologie.

5. Système selon l'une quelconque des revendications 1 à 4, caractérisé en ce que lesdits moyens de comparaison (111, 216) sont adaptés pour certifier ladite participation lorsqu'il y a égalité, à une tolérance donnée près ($\tau$), entre lesdits temps relatifs mesurés dans le dispositif ($\delta T_{int}$) et dans le serveur ($\delta T_{ref}$).

6. Système selon l'une quelconque des revendications 1 à 5, caractérisé en ce que ledit dispositif comprend des moyens de traitement de données (4) pour produire un résultat fonction de ladite donnée de participation et les moyens de comparaison (111, 216) sont adaptés pour certifier ou non ledit résultat.

7. Système selon la revendication 6, caractérisé en ce que ledit serveur (S) comprend des moyens de stockage dans lesquels ledit résultat est mémorisé en réponse à ladite certification.

8. Système selon la revendication 7, caractérisé en ce que ledit dispositif comprend des moyens d'authentification (4) adaptés pour délivrer un code composite par codage, suivant un premier algorithme donné (A) en fonction d'une information de commande externe pouvant être chiffrée, comprenant un nombre aléatoire (a) et délivrée à partir dudit serveur (S), dudit résultat et d'un code d'identification (NII) propre au dispositif mémorisé dans lesdits moyens de mémorisation (11, 12), ledit serveur (S) étant adapté pour effectuer, au moyen dudit nombre aléatoire (a), suivant un algorithme (B) corrélé à l'algorithme (A), un calcul sur ledit code composite pour décoder ledit résultat et calculer un code d'identification externe (NIE), ledit résultat étant mémorisé dans lesdits moyens de stockage lorsqu'il y a cohérence dudit code d'identification externe (NIE) avec une information de contrôle connue du serveur.

9. Système selon la revendication 8, caractérisé en ce que lesdits moyens de comparaison sont disposés dans le serveur (S) et lesdits moyens d'authentification (4) sont adaptés pour produire un code composite comprenant également ledit temps mesuré dans ledit dispositif ($\delta T_{int}$), en vue de son application auxdits moyens de comparaison dans ledit serveur (S).

10. Système selon la revendication 6, caractérisé en ce que lesdits moyens de mémorisation sont adaptés pour mémoriser ledit résultat en réponse à ladite certification.

11. Système selon la revendication 10, caractérisé en ce que lesdits moyens de comparaison (111) sont disposés dans ledit serveur (S) et en ce que ledit dispositif comprend des moyens d'authentification comportant :

- des moyens (4) pour élaborer un certificat contenant ledit temps relatif ($\delta T_{int}$) mesuré dans ledit dispositif,
- des moyens (4) de chiffrement dudit certificat,
- des moyens ($I_1$) pour transmettre ledit certificat chiffré audit serveur,
- des moyens ($I_2$) pour recevoir dudit serveur, en réponse à ladite certification dudit résultat par lesdits moyens de comparaison, un code de validation chiffré comprenant une première clé de validation calculée par ledit serveur en fonction d'une information connue desdits moyens de traitement,
- des moyens (4) de déchiffrement dudit code de validation,
- des moyens (4) pour calculer une seconde clé de validation en fonction de ladite information connue des moyens de traitement,
- des moyens pour comparer lesdites première et seconde clés de validation, et
- des moyens (4) pour mémoriser ledit résultat dans lesdits moyens de mémorisation lorsqu'il y a cohérence entre lesdites première et seconde clés de validation.

12. Système selon la revendication 10, caractérisé en ce que les moyens de comparaison (216) sont disposés dans ledit dispositif (1) et en ce que ce dernier comprend des moyens d'authentification comportant :
- des moyens (4) de temporisation initialisés en réponse à une demande de validation d'un résultat,
- des moyens (4) pour élaborer un message caractéristique d'une demande de validation,
- des moyens pour chiffrer ledit message,
- des moyens ($I_1$) pour transmettre ledit message chiffré audit serveur (S),
- des moyens ($I_2$) pour recevoir dudit serveur (S) un certificat chiffré comprenant ledit temps relatif de référence ($\delta T_{ref}$) mesuré par ledit serveur,
- des moyens (4) pour déchiffrer ledit certificat et appliquer ledit temps relatif de référence ($\delta T_{ref}$) auxdits moyens de comparaison (216), et
- des moyens (4) pour mémoriser ledit résultat dans lesdits moyens de mémorisation en réponse à ladite certification par lesdits moyens de comparaison si le temps mesuré par lesdits moyens de temporisation (201) est inférieur à une durée limite prédéterminée.

13. Système selon l'une quelconque des revendications 11 et 12, caractérisé en ce que ledit certificat ou ledit message transmis par le dispositif (1) au serveur (S) comprend une information secrète (a) connue desdits moyens de traitement et en ce que ledit code de validation ou ledit certificat transmis du serveur (S) au dispositif (1) est chiffré en fonction de ladite information secrète,

14. Système selon l'une quelconque des revendications 11 à 13, caractérisé en ce que ledit certificat ou ledit message transmis par le dispositif au serveur est chiffré en fonction d'une information connue du serveur.

15. Système selon l'une quelconque des revendications 1 à 14, caractérisé en ce que lesdits moyens d'interface comprennent un clavier (8) à touches alphabétiques et/ou numériques (t) pour l'introduction de données dans le dispositif.

16. Système selon la revendication 15, caractérisé en ce que ledit dispositif comprend des moyens d'identification (4) adaptés pour comparer un code introduit au clavier (8) avec un code confidentiel d'identification (NID) mémorisé dans lesdits moyens de mémorisation (11, 12) et pour rendre actif le dispositif en cas de coïncidence desdits codes.

17. Système selon l'une quelconque des revendications 1 à 16, caractérisé en ce que lesdits moyens d'interface comprennent des moyens de réception de données codées télédiffusées représentatives dudit scénario de participation associé audit programme.

18. Système selon la revendication 17, caractérisé en ce que lesdites données de scénario sont chiffrées et le dispositif (1) comporte des moyens de déchiffrement desdites données.

19. Système selon l'une quelconque des revendications 17 et 18, caractérisé en ce que les moyens de réception (R) sont constitués par des moyens optiques (3) de lecture de données transmises sous forme lumineuse.

20. Système selon l'une quelconque des revendications 1 à 19, caractérisé en ce que lesdits moyens d'interface comprennent des moyens (7) d'affichage d'informations mémorisées et/ou traitées dans le dispositif.

21. Système selon l'une quelconque des revendications 1 à 20, caractérisé en ce que les moyens de déchiffrement, de traitement de données, de certification, d'authentification, de temporisation et d'identification sont constitués par un microcalculateur programmé (4) couplé aux moyens de mémorisation (11, 12) et aux moyens d'interface (7, 8, R).

22. Système selon la revendication 21, caractérisé en ce que ladite horloge comprend une base de temps (10) alimentée en permanence par une source d'alimentation électrique et couplée audit microcalculateur (4), ledit microcalculateur étant programmé pour mesurer le temps écoulé depuis la mémorisation d'une donnée représentative de la durée de vie autorisée du dispositif, et pour inhiber le fonctionnement du dispositif à l'expiration de ladite durée de vie prédéterminée.

23. Système selon l'une quelconque des revendications 1 à 22, caractérisé en ce qu'il comprend :
- des dispositifs de participation (1) associés chacun à un individu participant audit programme,
- des moyens (E) de diffusion dudit programme à des postes de réception (16),
- des terminaux (13) pour l'établissement de liaisons de certification entre lesdits dispositifs de participation (1) et ledit serveur (s).

24. Système selon la revendication 23, caractérisé en ce qu'il comprend des terminaux pour débiter le(s) résultat(s) stocké(s) dans des moyens de mémorisation desdits dispositifs.

25. Système selon l'une quelconque des revendications 23 et 24, caractérisé en ce que lesdits postes de réception (16) comportent un écran de visualisation (15) dudit programme et en ce que lesdits moyens de diffusion (E) sont adaptés pour transmettre à des moyens de réception optiques (R) des dispositifs de participation (1) des données de scénario affichées sous forme lumineuse sur lesdits écrans de visualisation.

26. Système selon l'une quelconque des revendications 24 et 25, caractérisé en ce que lesdits terminaux (13; 302) comprennent des moyens pour transmettre sous forme lumineuse des données auxdits moyens de réception optiques (R) desdits dispositifs de participation (1).

27. Système selon l'une quelconque des revendications 23 à 26, caractérisé en ce que lesdits terminaux (302) comprennent des moyens (317) de lecture d'informations affichées sous forme codée sur un écran d'affichage (7) desdits dispositifs de participation (1).

**Patentansprüche**

1. System zur Teilnahme mindestens einer Person an einem fernübertragenen Programm gemäß eines Programmablaufs (Szenario), der in einer individuellen und autonomen elektronischen Vorrichtung zur Teilnahme und zur Bestätigung dieser Teilnahme in Verbindung mit einem Server gespeichert ist, welches folgendes aufweist:
- Schnittstellenmittel zur Eingabe von mindestens einem für die Programmteilnahme repräsentativen Datensatz durch einen Teilnehmer und zum Aufbau einer Verbindung zur Bestätigung mit dem Server,
- Mittel zur Speicherung des Teilnahmedatensatzes und des Programmablaufs, und
- eine Uhr,

dadurch gekennzeichnet, daß:

- die Vorrichtung (1) Mittel (4, 10) zur Messung der relativen Zeit ($\delta T_{int}$) aufweist, die zwischen zumindest einem ersten Ereignis des Programmablaufs, welcher chronologisch in Beziehung mit der Eingabe eines Teilnahmedatensatzes in die Vorrichtung steht, und dem Aufbau der Verbindung zur Bestätigung mit dem Server (S) vergangen ist,
- der Server (S) Mittel (110, 208) zur Messung der relativen Zeit ($\delta T_{int}$) aufweist, die zwischen zumindest einem zweiten Ereignis des Programms, welches chronologisch in Beziehung mit einem absoluten Grenzzeitpunkt zur Eingabe des Teilnahmedatensatzes steht, und dem Aufbau der Verbindung zur Bestätigung vergangen ist, und
- die Vorrichtung und/oder der Server Mittel (111, 216) aufweisen zum Vergleich der in der Vorrichtung und dem Server gemessenen Relativzeiten und zur Bestätigung oder Nicht-Bestätigung der Teilnahme in Abhängigkeit vom Ergebnis des Vergleichs.

2. System nach Anspruch 1, dadurch gekennzeichnet, daß das erste Ereignis aus der Eingabe eines Teilnahmedatensatzes in die Vorrichtung besteht.

3. System nach einem der Ansprüche 1 und 2, dadurch gekennzeichnet, daß das zweite Ereignis aus dem absoluten Grenzzeitpunkt zur Eingabe eines Teilnahmedatensatzes in die Vorrichtung besteht.

4. System nach einem der Ansprüche 1 bis 3, dadurch gekennzeichnet, daß der Programmablauf repräsentative Parameter des chronologischen Ablaufs des Programms enthält, und dadurch, daß die Vorrichtung Zeitgebermittel zur Durchführung des Programmablaufs nach dieser Chronologie aufweist.

5. System nach einem der Ansprüche 1 bis 4, dadurch gekennzeichnet, daß die Vergleichsmittel (111, 216) geeignet sind, die Teilnahme zu bestätigen, falls innerhalb eines gegebenen engen Toleranzrahmens ($\tau$) zwischen den in der Vorrichtung ($\delta T_{int}$) und dem Server ($\delta T_{ref}$) gemessenen Relativzeiten Gleichheit besteht.

6. System nach einem der Ansprüche 1 bis 5, dadurch gekennzeichnet, daß die Vorrichtung Mittel zur Datenverarbeitung (4) umfaßt zur Lieferung eines Ergebnisses, das von dem Teilnahmedatensatz abhängt, und daß die Vergleichsmittel (111, 216) geeignet sind zur Bestätigung oder Nicht-Bestätigung des Ergebnisses.

7. System nach Anspruch 6, dadurch gekennzeichnet, daß der Server (S) Speichermittel aufweist, in denen das Ergebnis nach erfolgter Bestätigung abgelegt wird.

8. System nach Anspruch 7, dadurch gekennzeichnet, daß die Vorrichtung Mittel zur Authentifikation (4) aufweist, die geeignet sind, einen durch Codierung zusammengesetzten Code auszugeben, wobei die Codierung gemäß eines ersten gegebenen Algorithmus (A), welcher abhängig ist von externen, vom Server (S) stammenden Befehlsinformationen, die chiffriert sein können und eine Zufallszahl (a) enthalten, des Ergebnisses und des der Vorrichtung eigenen, in den Speichermitteln gespeicherten Identifikationscodes (NII) erfolgt, und wobei der Server (S) mittels der Zufallszahl (a) und gemäß eines mit dem Algorithmus (A) korrelierten Algorithmus (B) in der Lage ist, aus diesem Code das decodierte Ergebnis und einen externen Identifikationscode (NIE) zu berechnen, und das Ergebnis in Speichermitteln abgelegt wird, falls der externe Identifikationscode (NIE) mit dem Server bekannten Kontrolldaten kohärent ist.

9. System nach Anspruch 8, dadurch gekennzeichnet, daß sich die Vergleichsmittel im Server (S) befinden, und die Mittel zur Authentifikation (4) geeignet sind zur Erzeugung eines zusammengesetzten Codes, welcher auch die in der Vorrichtung gemessene Zeit ($\delta T_{Int}$), im Hinblick auf ihre Verwendung mit den Vergleichsmitteln im Server (S), enthält.

10. System nach Anspruch 6, dadurch gekennzeichnet, daß die Speichermittel geeignet sind, das Ergebnis nach erfolgter Bestätigung zu speichern.

11. System nach Anspruch 10, dadurch gekennzeichnet, daß sich die Vergleichsmittel (111) im Server (S) befinden, und dadurch, daß die Vorrichtung Mittel zur Authentifikation enthält, welche folgendes aufweisen:
   - Mittel (4) zur Ausarbeitung einer Bestätigung, welche die in der Vorrichtung gemessene Relativzeit ($\delta T_{Int}$) beinhaltet,
   - Mittel (4) zur Chiffrierung der Bestätigung,
   - Mittel ($I_1$) zur Übertragung der chiffrierten Bestätigung zum Server,
   - Mittel ($I_2$), um nach erfolgter Bestätigung des Ergebnisses durch die Vergleichsmittel einen chiffrierten Freigabecode vom Server zu empfangen, der einen ersten Freigabeschlüssel aufweist, welcher durch den Server in Abhängigkeit von Daten, die den Verarbeitungsmitteln bekannt sind, berechnet wird,

   - Mittel (4) zur Dechiffrierung des Freigabecodes,
   - Mittel (4) zur Berechnung eines zweiten Freigabeschlüssels, abhängig von Daten, die den Verarbeitungsmitteln bekannt sind.
   - Mittel zum Vergleich des ersten und des zweiten Freigabeschlüssels, und
   - Mittel (4), um das Ergebnis in den Speichermitteln abzulegen, falls der erste und zweite Freigabeschlüssel miteinander kohärent sind.

12. System nach Anspruch 10, dadurch gekennzeichnet, daß die Vergleichsmittel (216) in der Vorrichtung (1) angeordnet sind, und dadurch, daß letztere Mittel zur Authentifikation enthält, welche folgendes aufweisen:
   - Zeitgebermittel (4), die bei Vorliegen einer Anfrage zur Freigabe eines Ergebnisses initialisiert werden,
   - Mittel (4) zur Ausarbeitung einer charakteristischen Nachricht für eine Freigabeanfrage,
   - Mittel zur Chiffrierung der Nachricht,
   - Mittel ($I_1$) zur Übertragung der chiffrierten Nachricht zum Server,
   - und Mittel ($I_2$), um vom Server (S) eine chiffrierte Bestätigung zu empfangen, welche die vom Server gemessene Bezugsrelativzeit ($\delta T_{ref}$) enthält,
   - Mittel (4), um die Bestätigung zu dechiffrieren, und um die Bezugsrelativzeit ($\delta T_{ref}$) auf die Vergleichsmittel (216) anzuwenden, und
   - Mittel (4), um das Ergebnis nach der durch die Vergleichsmittel erfolgten Bestätigung in den Speichermitteln abzulegen, falls die durch die Verzögerungsmittel (201) gemessene Zeit geringer ist als eine vorher bestimmte begrenzte Zeitspanne.

13. System nach einem der Ansprüche 11 und 12, dadurch gekennzeichnet, daß die von der Vorrichtung (1) zum Server (S) übertragene Bestätigung oder Nachricht geheime, den Verarbeitungsmitteln bekannte Information (a) enthält, und dadurch, daß die vom Server (S) zur Vorrichtung (1) übertragene Freigabe oder Bestätigung abhängig von der geheimen Information verschlüsselt ist.

14. System nach einem der Ansprüche 11 bis 13, dadurch gekennzeichnet, daß die von der Vorrichtung zum Server übertragene Bestätigung oder Nachricht abhängig von dem Server bekannter Information verschlüsselt ist.

15. System nach einem der Ansprüche 1 bis 14, dadurch gekennzeichnet, daß die Schnittstellenmittel eine Tastatur (8) mit alphabetischen und/oder numerischen (t) Tasten zur Eingabe der Daten in die Vorrichtung umfassen.

16. System nach Anspruch 15, dadurch gekennzeichnet, daß die Vorrichtung Mittel (4) zur Identifikation besitzt, die geeignet sind, einen mittels der Tastatur eingegebenen Code mit einem vertraulichen Identifikations- code (NID), welcher in den Speichermitteln (11, 12) abgelegt ist, zu vergleichen und die Vorrichtung im Fall von Übereinstimmung der Codes zu aktivieren.

17. System nach einem der Ansprüche 1 bis 16, dadurch gekennzeichnet, daß die Schnittstellenmittel über Empfangsmittel für fernübertragene, codierte Daten verfügen, welche repräsentativ für den zu dem Programm gehörenden Programmablauf einer Teilnahme sind.

18. System nach Anspruch 17, dadurch gekennzeichnet, daß die Daten zum Programmablauf chiffriert sind und die Vorrichtung (1) über Mittel zur Dechiffrierung der Daten verfügt.

19. System nach einem der Ansprüche 17 und 18, dadurch gekennzeichnet, daß die Empfangsmittel (R) durch optische Mittel (3) zum Lesen der in Lichtform übertragenen Daten gebildet werden.

20. System nach einem der Ansprüche 1 bis 19, dadurch gekennzeichnet, daß die Schnittstellenmittel über Mittel (7) zum Anzeigen von in der Vorrichtung gespeicherten und/oder verarbeiteten Daten verfügen.

21. System nach einem der Ansprüche 1 bis 20, dadurch gekennzeichnet, daß die Mittel zur Entschlüsselung, zur Datenverarbeitung, zur Bestätigung, zur Authentifikation, zur Zeitgabe und zur Identifikation durch einen programmierten Rechnerchip (4) gebildet werden, der mit den Speichermitteln (11, 12) und den Schnittstellenmitteln (7, 8, R) verschaltet ist.

22. System nach Anspruch 21, dadurch gekennzeichnet, daß die Uhr über eine Zeitbasis (10) verfügt, welche dauernd von einer elektrischen Stromquelle versorgt wird und mit dem Rechnerchip (4) verschaltet ist, wobei der Rechnerchip darauf programmiert ist, die seit der Speicherung eines für die autorisierte Lebensdauer der Vorrichtung repräsentativen Datensatzes vergangene Zeit zu messen, und das Funktionieren der Vorrichtung nach Ablauf der vorbestimmten Lebensdauer zu verhindern.

23. System nach einem der Ansprüche 1 bis 22, dadurch gekennzeichnet, daß folgendes vorgesehen ist:
   - Teilnahmevorrichtungen (1), die jeweils zu einer an dem Programm teilnehmenden Person gehören,
   - Mittel (E) zur Programmabstrahlung an Empfangseinheiten (16),
   - Terminals (13) zum Aufbau der Verbindung zur Bestätigung zwischen den Teilnahmevorrichtungen (1) und dem Server (S).

24. System nach Anspruch 23, dadurch gekennzeichnet, daß es über Terminals zur Ausgabe des oder der in den Speichermitteln der Vorrichtungen abgelegten Ergebnisse(s) verfügt.

25. System nach einem der Ansprüche 23 und 24, dadurch gekennzeichnet, daß die Empfangseinheiten (16) über einen Bildschirm (15) zur Visualisierung oder Sichtbarmachung des Programmes verfügen, und dadurch, daß die Abstrahlungsmittel (E) geeignet sind, an die optischen Empfangsmittel (R) der Teilnahmevorrichtungen (1) Programmablaufsdaten zu übertragen, die in Lichtform auf den Bildschirmen angezeigt werden.

26. System nach einem der Ansprüche 24 und 25, dadurch gekennzeichnet, daß die Terminals (13, 302) Mittel zur Übertragung der Daten in Lichtform an die optischen Empfangsmittel (R) der Teilnahmevorrichtungen (1) besitzen.

27. System nach einem der Ansprüche 23 bis 26, dadurch gekennzeichnet, daß die Terminals (302) Mittel (317) zum Lesen von Informationen besitzen, die in codierter Form auf einem Anzeigebildschirm (7) der Teilnahmevorrichtungen (1) dargestellt sind.

**Claims**

1. System for participation of at least an individual to a broadcast program, according to a scenario stored in an individual and independent electronic device for participation, and for certification of said participation in association with a server, in which said device comprises :
   * interface means for the entry by a participant of at least one datum representative of said participation in said program and the establishment of a certification link with said server,
   * means for memorizing said participation datum and said scenario, and
   * a clock,
      characterized in that :

\* said device (1) comprises means (4, 10) for measuring the relative time ($\delta T_{int}$) elapsed between at least a first event of said scenario chronologically correlated with said entry of a participation datum in the device and the establishment of said certification link with the server (S),

- the server (S) comprises at least means (110, 208) for measuring the relative time ($\delta T_{ref}$) elapsed between at least a second event of said program chronologically correlated with an absolute deadline for the entry of said participation datum and the establishment of said certification link, and

- the device and/or the server comprise(s) means (111, 216) for comparing the relative times measured in the device and the server and for certifying or not certifying said participation as a function of the result of said comparison.

2. System accordin to claim 1, characterized in that said first event is constituted by said entry of a participation datum in the device.

3. System according to any of claims 1 and 2, characterized in that said second event is constituted by said absolute deadline of entry of a participation datum in the device.

4. System according to any of claims 1 to 3, characterized in that said scenario comprises parameters representing the chronological running of said program and in that said device comprises timing means for the implementation of said scenario according to said chronology.

5. Device according to any of claims 1 to 4, characterized in that said means of comparison (111, 216) are adapted for certifying said participation when there is equality, to within a given tolerance ($\tau$), between said relative times measured in the device ($\delta T_{int}$) and in the server ($\delta T_{ref}$).

6. System according to any of claims 1 to 5, characterized in that said device comprises means of data processing (4) for producing a result which is a function of said participation datum and the means of comparison (111, 216) are adapted to certify or not to certify said result.

7. System according to claim 6, characterized in that said server (S) comprises means of storage in which said result is credited in response to said certification.

8. System according to claim 7, characterized in that said device comprises means of authentication (4) adapted for supplying a composite code by encoding, according to a first given algorithm (A) as a function of an external control information which can be encoded, comprising a random number (a) and supplied from said server (S), of said result and of an internal identification code (NII) belonging to the device stored in said means of memorizing (11, 12), said server (S) being adapted for carrying out, using said random number (a), according to a second algorithm (B) correlated with said first algorithm (A), a computation on said composite code in order to decode said result and to compute an external identification code (NIE), said result being stored in said means of storage when there is consistency between said external identification code (NIE) and a check information known to the server.

9. System according to claim 8, characterized in that said means of comparison are disposed in the server (S) and said means of authentication (4) are adapted for producing a composite code also comprising said time measured in said device ($\delta T_{int}$), for the purpose of its application to said means of comparison in said server (S).

10. System according to claim 6, characterized in that said means for memorizing are adapted for storing said result in response to said certification.

11. System according to claim 10, characterized in that said means of comparison (111) are disposed in said server (S) and in that said device comprises means of authentication comprising :
   - means (4) for generating a certificate containing said relative time ($\delta T_{int}$) measured in said device,
   - means (4) for encoding said certificate,
   - means ($I_1$) for transmitting said encoded certificate to said server,
   - means ($I_2$) for receiving from said server, in response to said certification of said result by said means of comparison, an encoded validation code comprising a first validation key computed by said server as a function of an information known to said processing means,
   - means (4) for decoding said validation code,
   - means (4) for computing a second validation key as a function of said information known to the processing means,
   - means for comparing said first and second validation keys, and
   - means (4) for storing said result in said memorizing means when there is consistency between said first and second validation keys.

12. System according to claim 10, characterized in that the means of comparison (216) are disposed in said device (1) and in that the latter comprises means of authentication comprising :
   - means (4) of timing initialized in response to a request for validation of a result,
   - means (4) for generating a message characteristic of a validation request,
   - means for encoding said message,
   - means ($I_1$) for transmitting said encoded message to said server (S),
   - means ($I_2$) for receiving from said server (S) an encoded certificate comprising said relative reference time ($\delta T_{ref}$) measured by said server,
   - means (4) for decoding said certificate and applying said relative reference time ($\delta T_{ref}$) to said means of comparison (216), and
   - means (4) for storing said result in said memorizing means in response to said certification by said means of comparison if the time measured by said timing means (201) is less than a predetermined limit duration.

13. System according to either of claims 11 or 12, characterized in that said certificate or said message transmitted by the device (1) to the server (S) comprises a secret information (a) known to said processing means and in that said validation code or said certificate transmitted from the server (S) to the device (1) is encoded as a function of said secret information.

14. System according to any of claims 11 to 13, characterized in that said certificate or said message transmitted by the device to the server is encoded as a function of an information known to the server.

15. System according to any of claims 1 to 14, characterized in that said interface means comprise a keyboard (8) with alphabetic and/or numerical keys (t) for the entry of data into the device.

16. System according to claim 15, characterized in that said device comprises means of identification (4) adapted for comparing a code entered at the keyboard (8) with a confidential identification code (NID) stored in said memorizing means (11, 12) and for activating the device when there is coincidence between said codes.

17. System according to any of claims 1 to 16, characterized in that said interface means comprise means of reception of broadcast encoded data representative of said participation scenario associated with said program.

18. System according to claim 17, characterized in that said scenario data are encoded and the device (1) comprises means of decoding said data.

19. System according to either of claims 17 or 18, characterized in that the reception means (R) are constituted by optical means (3) for reading data transmitted in luminous form.

20. System according to any of claims 1 to 19, characterized in that said interface means comprise means (7) for displaying information stored and/or processed in the device.

21. System according to any one of claims 1 to 20, characterized in that said means of decoding, of data processing, of certification, of authentication, of timing and of identification, are constituted by a programmed microcomputer (4) coupled to the memorizing means (11, 12) and to the interface means (7, 8, R).

22. System according to claim 21, characterized in that said clock comprises a time base (10) continuously supplied by an electrical power supply source and coupled to said microcomputer (4), said microcomputer being programmed to measure the time elapsed since the storage of a datum representative of the authorized lifetime of the device, and to inhibit the function of the device when said predetermined lifetime has expired.

23. System according to any of claims 1 to 22, characterized in that it comprises :
   - a plurality of devices for participation (1) each associated with an individual participating in said program,
   - means (E) for broadcasting said program to receiving sets (16), and
   - terminals (13) for the establishment of certification links between said participation devices (1) and said server (S).

24. System according to claim 23, characterized in that it comprises terminals for debiting said result(s) stored in memorizing means of said devices.

25. System according to either of claims 23 or 24, characterized in that said receiving sets (16) comprise a screen (15) for the display of said program and in that said means of broadcasting (E) are adapted for transmitting to the optical reception means (R) of the participation devices (1) scenario data displayed in luminous form on said display screens.

26. System according to either of claims 24 or 25, characterized in that said terminal (13 ; 302) comprise means of transmitting data in luminous form to said optical reception means (R) of said participation devices (1).

27. System according to any of claims 23 to 26, characterized in that said terminals (302) comprise means (317) for reading information displayed in encoded form on a display screen (7) of said participation devices (1).

FIG.:1

FIG.:3

FIG.:2

FIG.:4

DEMANDE
AUTHENT.
OPTIQUE

DEMANDE
AUTHENT.
CLAVIER

FIG.:5

DÉCODAGE
ÉTAT
AUTHENT. —— 50

TRAME AUTHENTIFICATION

DÉCHIF_
FREMENT —— 51

CORRECT

NON
CORRECT

52

CERTIFICATION
(COMPARAISON)
$\delta T$ réf _ $\delta T$ int

CODE
COMPOSITE
NON
COHÉRENT —— 56

$\delta T$
INCORRECT

$\delta T$ CORRECT

CHIFFREMENT
CODE COMP.
N II / '0'

CHIFFREMENT
CODE COMP.
N II / Nbre Pts —— 53

55

CODE COMPOSITE

AFFICHAGE
CODE COM_
POSITE —— 54

FIG.:6

$\delta T$ int.

$t$

$T_0$   $T_1$   $T_2$   $T_3$   $T_4$   $T_5$   $T'_5$   $T_6$

$\delta T$ réf.

23

FIG.: 7

EP 0 399 897 B1

FIG.: 8

DISPOSITIF 1                    SERVEUR S

APPUYER SUR TOUCHE
"VALIDATION" — 100

LECTURE δt int — 101

GENERATION
CERTIFICAT: — 102
- EN-TETE
- a
- CCC
- δt int

| 103 CHIFF. | → | 104 C R C | → | I1 | → | 105 C R C | → | 106 DECHI. | → | 107 COHERENCE CCC? | NON → REJET |

OUI

| 110 CALCUL δt ref | | EXTRACTION ET MEMORISATION a — 108 | | EXTRACTION δt int — 109 |

111 — COMPARAISON

112 — δt int VALIDE? — NON → REJET

OUI

113 — ELABORATION CODE
DE VALIDATION:
- a
- CLE DE VALIDATION
  SERVEUR
- CCC

116 — CONTROLE

117 — DECHI.

118 — COHERENCE CCC? — NON → REJET

OUI

119 — CALCUL
CLE DE VALIDATION
DISPOSITIF

120 — CLE VALID. DISPOS.
=
CLE VALID. SERVEUR ? — NON → REJET

I2

| 115 C R C | ← | 114 CHIFF. |

OUI

121 — VALIDATION

122 — CALCUL GAIN

123 — GAIN CREDITE EN
MEMOIRE PROTEGEE

FIG.:9

DISPOSITIF 1                          SERVEUR S

APPUYER SUR TOUCHE "VALIDATION" — 200

TEMPORISATION T — 201

GENERATION MESSAGE: — 202
- EN-TETE
- a
- CCC

203 — CHIFF.

204 — C R C

I1

205 — CONTROLE

206 — DECHI.

NON ← COHERENCE?  207
REJET
OUI

208 — LECTURE δt ref

209 — EXTRACTION a

210 — ELABORATION CERTIFICAT
- δt ref
- a
- CCC

213 — CONTROLE

214 — DECHI.

215 — LECTURE δt int

216 — COHERENCE δt int ET δt ref ?  → NON
REJET
OUI

217 — TEMPS ECOULE  → OUI
REJET
NON

I2

212 — C R C

211 — CHIFF.

218 — VALIDATION

219 — CALCUL GAIN

220 — GAIN CREDITE EN MEMOIRE PROTEGEE

FIG.: 10

27

FIG.:11

FIG.:12